(19) Europäisches Patentamt
European Patent Office
Office européen des brevets

(11) Publication number : 0 210 007 B1

# (12) EUROPEAN PATENT SPECIFICATION

(45) Date of publication of patent specification : 27.02.91 Bulletin 91/09

(51) Int. Cl.$^5$ : H04N 17/00, H04B 17/00, H04B 3/46, G01R 23/20

(21) Application number : 86305171.0

(22) Date of filing : 03.07.86

## (54) Distortion surveillance apparatus.

(30) Priority : 04.07.85 JP 147538/85
04.07.85 JP 147551/85
04.07.85 JP 147552/85

(43) Date of publication of application : 28.01.87 Bulletin 87/05

(45) Publication of the grant of the patent : 27.02.91 Bulletin 91/09

(84) Designated Contracting States : DE FR GB NL

(56) References cited :
DE-A- 2 111 817
DE-B- 1 019 707
DE-B- 1 076 174
DE-B- 2 339 981
US-A- 4 365 346

(73) Proprietor : MATSUSHITA ELECTRIC INDUSTRIAL CO., LTD.
1006, Oaza Kadoma
Kadoma-shi, Osaka-fu, 571 (JP)

(72) Inventor : Takai, Hitoshi
Syokei-ryo 7-4-2, Kourigaoka
Hirakata-shi Osaka-fu, 573 (JP)
Inventor : Morotomi, Noriaki
2666-18, Chougo
Fujisawa-shi Kanagawa-ken, 252 (JP)

(74) Representative : Crawford, Andrew Birkby et al
A.A. THORNTON & CO. Northumberland
House 303-306 High Holborn
London WC1V 7LE (GB)

EP 0 210 007 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

1. Field of the Invention

This invention relates to a distortion surveillance apparatus for detecting abnormal increase of signal distortion occurring in the trunk amplifier or the like used in the transmission system of television signals such as CATV system.

2. Description of the Prior Art

Recently, CATV tends to have more number of channels. Accordingly particularly high performances are required for the transmission system, especially, for the trunk amplifier. Main factors for lowering the reliability of such transmission system are mostly related to the trunk amplifier, which includes active elements.

As one of the troubles relating to the trunk amplifier, increase of signal distortion due to excessive signal level or trouble of the amplifier is known. If occurrence of such increased signal distortion can be detected earlier and the defective position can be identified, the time required to restore the system can be curtailed. Such function can be realized by a remote-monitoring distortion surveillance apparatus.

Conventionally, to discover such trouble due to increase of signal distortion, a pilot signal of a specific frequency is transmitted, and the level of the pilot signal is detected at the input or output of the trunk amplifier, thereby judging whether the transmitted television signal level is proper or not. Based on this judgement, an excessive signal level is detected, thereby indirectly discovering the trouble due to increased signal distortion. Such trouble detecting unit is installed in the trunk amplifier, and has one-way or two-way communication function. The status of each trunk amplifier is generally surveyed by exchanging data with the surveillance terminal installed at the head end or other place (for example, Japanese Unexamined Patent Publication No. 50-33723). Document DE-A-2111 817 discloses a similar distortion surveillance apparatus, in which a modulated pilot signal is transmitted, and wherein the distortion level is determined according to ghe change of level of the modulation.

In the conventional method, however, it may not be always possible to detect the distortion which occurs when the input of the line amplifier becomes partially excessive due to disturbance of the in-band frequency characteristics. This is because the detecting unit is responsive only to the frequency of the pilot signal. Or, if the line amplifier has a push-pull construction, the trouble cannot be detected when the distortion is increased due to a trouble of the line amplifier itself, such as broken balance of this construction, while the pilot signal level is normal.

SUMMARY OF THE INVENTION

It is hence a primary object of this invention to provide a distortion surveillance apparatus capable of detecting directly and accurately an occurrence of a trouble to television signals due to increase of signal distortion.

To achieve this object, a distortion surveillance apparatus of the invention used in a transmission system for signals including a television signal, comprises : means coupled to a first specified position in said transmission system for supplying a pilot signal to said transmission system ; first extraction means coupled to a second specified position in said transmission system for extracting said pilot signal which has been subjected to a cross modulation with said television signal via a nonlinearity of said transmission system between said first and second specified positions ; rectifying means for obtaining an envelope of said cross modulated pilot signals from an output signal of said first extraction means ; second extraction means for extracting from said envelope at least a signal component of a horizontal scanning frequency of television signal and its harmonic components ; level detection means for detecting a level of a signal extracted by said second extraction means ; and judging means for producing a signal indicating an occurrence of abnormal signal distortion increase when said level detected by said level detection means becomes abnormally large.

In this construction, it is intended to survey a level of a signal having the horizontal scanning frequency or its higher harmonic component, out of the cross modulation components from the transmitted television signal to the pilot signal. An increase of the levels is judged to be abnormal, so that the trouble due to increase of distortion in the transmission system can be accurately detected.

## BRIEF DESCRIPTION OF THE DRAWINGS

FIG. 1 is a block diagram showing a distortion surveillance apparatus according to a first embodiment of this invention ;

FIG. 2 is a circuit diagram showing an example of pilot signal generator 102 in FIG. 1 ;

FIG. 3 is a block diagram showing a distortion detecting part 106 in FIG. 1 ;

FIG. 4 is a block diagram showing a first construction example of pilot signal extraction detector 301 in FIG. 3 ;

FIG. 5 shows frequency spectra of signals of various parts in FIG. 3 ;

FIG. 6 and FIG. 7 are circuit diagrams showing examples of pilot signal amplifier 402 and rectifier 403 in FIG. 4 respectively ;

FIG. 8 is a block diagram showing a second construction example of pilot signal extraction rectifier 301 in FIG. 3 ;

FIG. 9 is a circuit diagram of double balanced mixer as an example of frequency converter 802 in FIG. 8 ;

FIG. 10, FIG. 11, FIG. 12, and FIG. 13 are circuit diagrams as examples of horizontal scanning frequency component (HSFC) extraction filter 302 in FIG. 3 ;

FIG. 14 is a circuit diagram showing an example of level detector 303 in FIG. 3 ;

FIG. 15 is a circuit diagram showing an example of judging circuit 304 in FIG. 3 ;

FIG. 16 is an example of construction of CATV transmission system ;

FIG. 17 is a block diagram showing the inside of head end 1601 in FIG. 16 ;

FIG. 18 is a block diagram showing the inside of trunk amplifier 1605 in FIG. 16 ;

FIG. 19 is a block diagram showing a distortion surveillance apparatus according to a second embodiment of this invention ;

FIG. 20 is a circuit diagram showing an example of attenuator 1905 in FIG. 19 ;

FIG. 21 and FIG. 22 are block diagrams showing a construction of pilot signal extraction rectifier 301 in the second embodiment ;

FIG. 23 is a circuit diagram showing examples of pilot signal amplifier 2102 and rectifier 2103 in FIG. 21 or intermediate frequency amplifier 2205 and rectifier 2206 in FIG. 22 ;

FIG. 24 is a block diagram showing a construction of trunk amplifier 1605 in FIG. 16 in which is installed the distortion surveillance apparatus according to the second embodiment of this invention ;

FIG. 25 is a block diagram showing a construction of trunk amplifier 1605 in FIG. 16 in which is installed a distortion surveillance apparatus according to a third embodiment of this invention ; and

FIG. 26 is a circuit diagram showing an example of frequency division multiplexing filters 2501, 2507 in FIG. 25.

## DESCRIPTION OF THE PREFERRED EMBODIMENTS

FIG. 1 is a block diagram showing a construction of a distortion surveillance apparatus according to a first embodiment of this invention.

In FIG. 1, numeral 101 denotes an input terminal, 102 is a pilot signal generator, 103 is a combining network, 104 is a transmission system, 105 is a splitter, 106 is a distortion detecting part, and 107 is an output terminal.

The route from input terminal 101 to output terminal 107 by way of combining network 103, transmission system 104, and splitter 105, is from end to end of an entire transmission system, or makes up a part of it. The transmission signal contains an amplitude-modulated television signal.

The transmission system 104 is an object of surveillance for distortion by means of the distortion surveillance apparatus. The transmission system 104 is either radio system or wire system, or a combined form of the two. The portion of wire system may be either coaxial cable or optical fiber, or a combination of them. Or, without containing transmission line, the transmission system 104 may be only composed of an amplifier or a nonlinear element which may generate distortion.

The pilot signal generator 102 generates sine waves of a specific amplitude at a frequency not overlapped with the transmission signal supplied from the input terminal 101, being capable of passing through the transmission system 104, that is, within the transmission band.

The pilot signal introduced through the combining network 103 passes through the transmission system 104 together with the transmission signal containing television signal.

When a signal passes through the transmission system 104 which is not linear, the output includes others than input signal components. Suppose the input signal x is expressed as :

$$x = A \cos at + B \cos bt \quad (1)$$

then the component corresponding to the so-called third order distortion, $x^3$, may be expressed by using eq. (1) as follows :

$$\begin{aligned} x^3 &= (A \cos at + B \cos bt)^3 \\ &= 1/4\ (A^3 \cos 3at + B^3 \cos 3bt) \\ &+ 3/4\ \{A^2 B \cos (2a \pm b)t + AB^2 \cos (2b \pm a)t\} \\ &+ 3/4\ (A^3 \cos at + B^3 \cos bt) \\ &+ 3/2\ (AB^2 \cos at + BA^2 \cos bt) \quad \ldots\ldots\ldots (2) \end{aligned}$$

At the right side of eq. (2), the first term is the third order harmonic component, the second term is an intermodulation component, the third term is a fundamental wave nonlinear component, and the fourth term is a cross modulation component. Furthermore, at the right side of eq. (1), supposing the first term to be an unmodulated pilot signal and the second term to be a television signal, the video base band signal may be expressed in terms of s(t) as follows :

$$B = 1 + s\,(t) \quad (3)$$

where A, a, b are constants. Now paying attention to $AB^2$ cos at which is a cross modulation component, it may be expressed by using eq. (3) as follows :

$$AB^2 \cos at = A(s(t)^2 + s(t) + 1) \cos at \quad (4)$$

This means that video base band signal component and its secondary distortion component appear in the pilot signal envelope of the output of the transmission system 104. On the other hand, the video base band signal s(t) has a very strong component in the horizontal scanning frequency and the frequency of its integer multiples. Therefore, by detecting the envelope of the output signal of the transmission system 104 and also detecting the increase of the level of the frequency component of the horizontal scanning frequency and of its integer multiple, the increase of distortion of the transmission system 104 can be detected..What must be noted here is that the method of detection of this distortion surveillance apparatus of the invention is not related with the frequency of the transmission signal or frequency of the pilot signal. Hence, at any frequency within the transmission band, distortion occurring due to excess level can be detected. This principle also holds true if the transmission signal applied to the input terminal 101 includes a plurality of television signals.

The output signal from the transmission system 104 is divided by the splitter 105, and enters the distortion detecting part 106. In the distortion detecting part 106, the cross-modulated pilot signal is extracted, and the envelope is detected, and the horizontal scanning frequency signal or its higher harmonic component is removed by a filter having a steep characteristic. By detecting the level of the output signal from this filter, it is judged that the distortion increase is abnormal when this level is abnormally elevated.

Below are described the pilot signal generator 102 and distortion detecting part 106 in further details.

FIG. 2 shows an example of pilot signal generator, in which numerals 202, 203, 205, 211, 212 and 215 are resistors for bias, 206, 213 and 216 are capacitors for bypass, and the resistor 207 and capacitor 210, and resistor 217 and capacitor 220 compose decoupling of the power source. Capacitor 208 and coil 209 make up a tank circuit of crystal oscillation circuit composed of transistor 224, crystal oscillator 204, feedback capacitance 201 and others. The resonance frequency of this tank circuit is nearly selected at the fundamental oscillation frequency of crystal oscillator 204 or its odd-number times frequency. In the former case, it oscillates at the fundamental oscillation frequency, and in the latter case it is overtone oscillation. The transistor 214 is responsible for amplifying or multiplying. Capacitor 218 and coil 219, and capacitor 222 and coil 223 respectively make up tank circuits, of which resonance frequency is the pilot frequency, and are intended to remove the spurious components occurring in the transistor 214, together with coupling capacitor 221.

FIG. 3 is a block diagram showing a construction of distortion detecting part 106. Numeral 301 is a pilot signal extraction rectifier which removes the cross-modulated pilot signal and detects the envelope. Numeral 302 is a horizontal scanning frequency component (HSFC) extraction filter which extracts the fundamental wave component or its higher harmonic component from the horizontal scanning frequency component in the output signal from the pilot signal extraction rectifier 301. Numeral 303 is a level detector for detecting the level of output signal from the horizontal scanning frequency component extraction filter 302. Numeral 304 is a judging circuit for delivering a failure signal to the judgement output terminal 304 when the output of the level detector 303 elevates and exceeds a certain threshold level.

Hereinafter, the pilot signal extraction rectifier 301, horizontal scanning frequency component extraction filter 302, level detector 303, and judging circuit 304, which are constituent elements of the block diagram in FIG. 3 showing the construction of the distortion detecting part 106, are described in more detail while referring to the practical circuit diagrams.

FIG. 4 is a block diagram showing a first construction example of pilot signal extraction rectifier 301.

Numeral 401 is a pilot signal extraction filter which extracts the pilot signal. The passing band of this filter must contain the sideband corresponding to the fundamental wave or its higher harmonic of the horizontal scanning frequency ($f_H$) to be extracted by the horizontal scanning frequency component extraction filter 302. Examples of signal spectra-of various parts are shown in FIG. 5. Here it is shown that the horizontal scanning frequency component extraction filter extracts the fundamental wave component of $f_H$ or horizontal scanning frequency, and in this case the pilot signal extraction filter 401 must pass the pilot carrier and one of the sidebands being remote by $\pm f_H$, or preferably, both of them. Furthermore, in order to prevent distortion in the rear stage, that is, pilot signal amplifier 402 and rectifier 403, transmission signals other than the pilot signal, in particular, television signals must be sufficiently attenuated. This pilot signal extraction filter 401 may be composed by using resonance circuit or LC filter composed of coils and capacitors, or filter using distribution constant circuit as represented by helical resonator, crystal filter, ceramic filter, or SAW filter.

Numeral 402 is a pilot signal amplifier which amplifies the pilot signal. Numeral 403 is a rectifier which detects the envelope of the pilot signal having been extracted by the pilot signal extraction filter 401 and amplified by pilot signal amplifier 402. The direct-current component of the output of the rectifier 403 indicates the carrier level of the pilot signal,and so as to make it constant, automatic gain control (AGC) is effected to control the amplitude of the pilot signal amplifier 402. In this way, the level of the pilot signal applied to the rectifier 403 is kept constant, thereby holding constant the distortion detection sensitivity. As the rectifier 403, various rectifier circuits using diodes, square rectifier, or synchronous rectifier may be used.

FIG. 6 is a circuit diagram as an example of pilot signal amplifier 402 and rectifier 403. The pilot signal amplifier 402 is realized by resistors for bias 602, 604, 606, 613, 615, 618, capacitors for bypass 601, 607, 616, 619, resistors and capacitors for power source decoupling 608, 611, 620, 623, resonance circuits tuned to pilot signal frequency 609, 610, 621, 622, and transistors 605, 617. The rectifier 403 is realized by a half-wave rectifier circuit composed of diode 624, and resistors and capacitors 625, 626, 627 which make up the filter to remove higher frequency components. The direct-current component of the output of the rectifier taken out by the filter composed of resistor 628 and capacitor 631 is amplified by the transistor 630 and load resistor 629, and is applied to the transistors 605, 617 by way of a decoupling circuit composed of capacitors 614, 603, and resistor 612 to change their base voltage, thereby effecting gain control.

FIG. 7 is similarly a circuit diagram of another example of pilot signal amplifier 402 and rectifier 403. What is difference from FIG. 6 is that synchronous rectification is effected by using an IC 719 for VIF, AN5125. In the rectifier 403, if a diode having an extreme nonlinearity as shown in FIG. 6 is used, the pilot signal is subjected to cross modulation by the television signal which has leaked, not being cut by the pilot signal extraction filter 401, and the sensitivity of distortion detection is lowered as a result. Therefore, as the rectifier 403, by using a synchronous rectifier which operates linearly, the detection sensitivity can be improved. In FIG. 7, capacitors 703, 704, 705, 706, 715 are for bypass, capacitors 707, 714, and coils 708, 713 are for power source decoupling, 702 is a time constant capacitor for AGC, 709 is a capacitor for lock detection filter for PLL (phase locked loop), and a resonance circuit composed of capacitor 716 and coil 717 is a resonance circuit for oscillation of VCO (voltage controlled oscillator) resonating at the pilot signal frequency.

FIG. 8 is a block diagram showing a second construction example of pilot signal extraction rectifier 301. In the first example shown in FIG. 4, the structure is simple, but it is hard to realize the pilot signal extraction filter 401 when the frequency of the pilot signal is high or there is a transmission signal very close to the pilot signal. Moreover it is also hard to realize pilot signal amplifier 402. In the second example shown in FIG. 8, it is intended to realize the desired band width and amplitude easily by converting the pilot signal to a lower intermediate frequency. The individual parts are specifically described below.

Numeral 801 is a first filter to pass the pilot signal. This first filter 801 is intended to eliminate transmission signal if contained in the image frequency. Incidentally, in order to reduce the occurrence of distortion at the frequency converter 802 mentioned later, it is desired to attenuate other transmission signals than the pilot signal, especially television signals, by this filter. As the first filter 801, a resonance circuit or LC filter composed of coils and capacitors, filter using distribution constant circuit such as helical resonator, or SAW filter may be used.

Numeral 803 is a local oscillator for oscillating local oscillation signal to convert the pilot signal to the intermediate frequency band. The difference between the local oscillation frequency and the pilot signal frequency is the intermediate frequency. Therefore, the local oscillation frequency may be either above or below the pilot signal frequency by the portion of the intermediate frequency. The circuit diagram is identical with that of FIG. 2 and is omitted here. However, the resonance frequency of the resonance circuits of 218, 219, and 222, 223 is the local oscillation frequency, and the resonance frequency of the resonance circuit 208, 209 is the primary oscillation frequency of an integer fraction of the local oscillation frequency. The fundamental oscillation of the crystal oscillator 204 or overtone oscillation frequency is this primary oscillation frequency.

Numeral 802 is a frequency converter to convert the frequency of the pilot signal to the intermediate frequency band. The frequency converter 802 is composed of bipolar transistor, junction type FET, MOSFET, MESFET, and diode, and those small in occurrence of distortion are preferred, and the structure of double balanced mixer is particularly preferable. A circuit example of double balanced mixer using diodes are shown in FIG. 9. Numerals 901, 906 are transformers bifilar wound on troidal core, and 902, 903, 904, 905 are diodes unified in characteristics.

Numeral 804 is a second filter to remove other signals than the pilot signal converted to the intermediate frequency band. The passing band width of this filter must contain, like the pilot signal extraction filter 401, the sideband corresponding to the fundamental wave or higher harmonic of $f_H$ to be extracted by the horizontal scanning frequency component extraction filter 302. For example, when extracting $f_H$, it is necessary to pass the frequency-converted pilot signal carrier together with at least either the upper or lower sideband by $\pm f_H$ from it, or preferably both of them. This second filter 804 may be composed of resonance circuit or LC filter made of coils and capacitors, crystal filter, ceramic filter, SAW filter, or mechanical filter.

Numeral 805 is an intermediate frequency amplifier, and 806 is a rectifier. These blocks are exactly the same in the functions as the above-mentioned pilot signal amplifier 402 and rectifier 403, except that the input signal frequency is changed from the pilot signal frequency to the frequencyconverted pilot signal frequency, that is, the intermediate frequency. Therefore, a practical example of circuit may be realized by changing the resonance frequency to the intermediate frequency in the resonance circuits 609, 610 and 621, 622 and 716, 717 in FIG. 6 and FIG. 7.

The next description relates to the horizontal scanning frequency component (HSFC) extraction filter 302.

This is a band pass filter that extracts the frequency component of $f_H$ or $mf_H$ (where m is an integer of not less than 2), and the passing band width of this filter affects the sensitivity as the distortion detection. In order to detect the distortion trouble until the cross modulation interference, that is, the window wiper interference is sensed visually, the passing band width must be set at 200 Hz, for example, with the $f_H$ filter and 100 Hz or less with the $2f_H$ filter. Furthermore, in order to detect the distortion trouble until the third order beat interference is sensed visually, the passing band width must be set at 13 Hz with the $f_H$ filter, and 6 Hz or less with the $2f_H$ filter. It is also necessary to prevent the horizontal scanning frequency component to be extracted from being dislocated from the passing band, due to drift or deviation of $f_H$ or drift or deviation of horizontal scanning frequency component extraction filter 302. The explanation continues below by referring to the circuit example.

FIG. 10 shows a circuit example using three-terminal type filter element. Numeral 1001 denotes an input resistor, 1003 is a terminal resistor, and 1002 is a three-terminal type filter element. The filter element 1002 can be realized by tuning fork type crystal oscillator, mechanical filter or ceramic filter. For example, when a tuning fork type crystal oscillator is used, the band width is about 2 Hz with $f_H$ filter. In the case of mechanical filter, the band width is about 20 Hz with $f_H$ filter. The ceramic filter is considerably large in shape, and it is hard to obtain narrow band width. In order to obtain out-band attenuation, several stages of filter elements 1002 may be connected in series.

FIG. 11, FIG. 12 are examples of circuits using twoterminal type tuning fork type crystal oscillator. Numerals 1101, 1201 are input resistors, 1109, 1209 are terminal resistors, 1102, 1104, 1106, 1108, 1203, 1205, 1207 are tuning fork type crystal oscillators, and 1103, 1105, 1107, 1109, 1202, 1204, 1206, 1208 are capacitors to compose a filter. By such ladder type circuit, the band width of about 4 Hz with $f_H$ filter and about 6 Hz with 2 $f_H$ filter may be easily obtained, and the out-band attenuation is more than 60 dB with four-element type. The tuning fork type crystal oscillator is high in capacitance ratio and Q value, and is considerably narrow in passing band width. With the $f_H$ filter, the band width is about 4 Hz as compared with the required band width of 13 Hz. If the drift or deviation of $f_H$ is large, a wider band width may be desired, and for example, when composed as shown in FIG. 13, the band width will be about twice as wide as that in FIG. 11 or FIG. 12. In this example, numeral 1301 is an input resistor, 1307 is a terminal resistor, and 1302, 1303, 1304, 1305, 1306 are tuning fork type crystal oscillators.

Next, the level detector 303 is described while referring to a practical circuit.

FIG. 14 is an example of circuit diagram of level detector 303. It is roughly divided into an amplifying state in three-stage structure comprising junction type FET 1401, and transistors 1411,1421,and a rectifying stage of diode 1429. In the amplifying state, numerals 1402, 1408, 1409, 1412, 1418, 1419, 1422 are resistors for bias ; 1404, 1406 and 1414, 1416 and 1425, 1427 are resistors and capacitors for power source decoupling ; 1405, 1407 and 1415, 1417 and 1426, 1428 are capacitors and coils of resonance circuit to resonate to the frequency of the components to be extracted by the horizontal scanning frequency component extraction filter 302 ; 1403, 1410, 1413, 1420, 1424 are capacitors for bypass ; and 1423 is a variable resistor for gain control. When the tuning fork type crystal oscillators are used in the horizontal scanning frequency component extraction filter 302, its input, output impedance is about several hundred kiloohms, and the initial step of the amplifying stage must receive with junction type or MOS type FET or emitter follower. In the rectifying stage, numeral 1430 is a charging resistor, 1431 is a discharging resistor, 1432 is a smoothing capacitor, and 1433 is an output resistor. The time constant of rise of output signal is the product of parallel resistances of resistors 1430, 1431 and capacitance of capacitor 1432, while the time constant of fall is similarly the product of capacitance of capacitor 1432 and resistance of resistor 1431. If plural television signals are transmitted as the transmission signals, the output signal may pulsate due to a slight difference in $f_H$ in the television signals, and it is preferable to adjust the peak-hold characteristic so that the time constant of rise may be shorter than that of fall.

Finally the judging circuit 304 is explained together with a practical circuit.

The judging circuit 304 is intended to judge it is abnormal at a certain threshold level when the output signal of the level detector 303 elevates. In order to prevent misoperation due to impulse or the above-mentioned pulsation, it is composed in a switching circuit having hysteresis characteristic. As an example, a Schmitt circuit is shown in FIG. 15. Numerals 1501, 1507 are collector resistors ; 1503, 1506 are transistors for switching ; 1502, 1505 are voltage dividing resistors for coupling from transistor 1503 to transistor 1506; and 1504 is an emitter resistor. Feedback is effected by the common emitter resistor 1504, and a hysteresis occurs in the threshold voltage.

Relating now to a practical example of transmission system 104 and the entire transmission system, and application of the distortion surveillance apparatus in the first embodiment of this invention in an entire transmission system is shown.

FIG. 16 shows a structure of a transmission system of typical CATV (cable television) as an example of the transmission system of television signals. In FIG. 16, numeral 1601 is a head end, 1602, 1603, 1605 are trunk amplifiers, 1606 is a tap-off, 1604, 1607 are terminators, 1608 is a terminal unit, 1609 is a television set, and 1610 is the center. The down transmission signals including television signals are first sent from the center 1610 to the head end 1601 by way of radio circuit, optical fiber or satellite. The head end 1601, receiving these down transmission signals, possesses the function of transmitting them to the coaxial line, together with on-air reception signals when re-transmitting on-air signals, or with signals for remote surveillance system (called status monitor) of transmission line to be mentioned later and various data signals to the terminal unit 1608, by multiplexing the frequency. The down transmission signals sent out from the head end 1601 onto the coaxial line are transmitted while compensating the attenuation in the coaxial line by trunk amplifiers 1602, 1603, 1605, as running through trunk amplifiers 1602, 1603, terminator 1604, or trunk amplifiers 1602, 1605, terminator 1607. On the way of the coaxial line there is a splitter called tap-off 1606, and the down transmission signals are branched off by the tap-off 1606, and enter the terminal unit 1608 at each home. The terminal unit 1608 possesses several functions, such as television signal tuning function, frequency converting function, descrambling function if the television signals are scrambled, and communication function with the head end. This explanation related to the down transmission in the direction from the center 1610 to the terminal unit 1608 by way of head end 1601, trunk amplifiers 1602, 1605, and tap-off 1606, but there are also many two-way transmission systems capable of transmitting also in the up direction in the reverse way (the CATV transmission system is, for example, mentioned in "Technology of CATV" by Genzaburo Kuraishi).

The combining network 103, pilot signal generator 102, and splitter 105 in FIG. 1 may be placed at any positions in FIG. 16. However, with respect to the flow of signal, the combining network 103 must be placed at the upstream side, and the splitter 105 at the downstream side. The distortion surveillance apparatus in the first embodiment of this invention may be applied to either up or down transmission system, but anyway amplitude-modulated television signals must be contained in the transmission signal flowing in the transmission system to be surveyed.

Furthermore, sharing a single pilot signal fed from the combining network 103 and pilot signal generator 102, plural sets of splitter 105 and distortion detecting part 106 may be prepared. For example, in FIG. 16, by placing the combining network 103 and pilot signal generator 102 at the head end 1601, and the splitter 105 and distortion detecting part 106 at the trunk amplifiers 1602, 1603, 1605 or terminators 1604, 1607 or tap-off 1606 or terminal unit 1608, the down transmission line from the head end 1601 to each splitter 105 may be surveyed. In this case, it is also possible to use this pilot signal as reference level signal for automatic adjustment of the level of transmission system parts, which will be further described below as a second embodiment of this invention.

Furthermore, it may be also possible to use plural sets of combining network 103 and pilot signal generator 102 generating pilot signals mutually different in frequency, placing them at various positions in the transmission system, and install a set or plural sets of corresponding flow splitter 105 and distortion detecting part 106 individually.

Further descriptions are devoted to an example of distortion surveillance of down transmission system from the head end 1601 to the installed trunk amplifiers by placing the combining network 103 and pilot signal generator 172 at the head end 1601 and the splitter 105 and distortion detecting part 106 at the trunk amplifiers 1602, 1603, 1605.

FIG. 17 shows the inside of head end 1601. Numeral 1701 is a head end transmitter/receiver which sends out the television signals or data signals from the center by frequency multiplexing, or receives the up television signals or data signals. Numeral 1704 is a frequency division multiplexing filter which separates the up and down transmission signals usually assigned in the low range and high range respectively by making use of the difference in frequency. The frequency division multiplexing filter 1704 is composed of low-pass filter and high-pass filter, or it may be composed of a mere combining network.

This is the construction of an ordinary head end. The example shown in FIG. 17 also comprises a surveillance terminal 1713 possessing the communication function to obtain information of occurrence of trouble and the function to analyze and display the information, and combining network 1702 and pilot signal generator 1705 which are exactly identical with the combining network 103 and pilot signal generator 102 in FIG. 1.

The surveillance terminal 1713 is composed of transmission modulation circuit 1707, reception demodulation circuit 1708, combining network 1703 and splitter 1706 for receiving trouble detection information from the trunk amplifiers, CPU control circuit 1709 for exchanging commands with the trunk amplifiers by way of the communication means, and obtaining, analyzing and compiling the trouble detection information, and CRT 1710, keyboard 1711 and printer 1712 for communicating with the operator. Such remote monitoring system of transmission line is called status monitor (for example, IEEE Trans. CATV-4, no. 3, pp. 103-110, "An Advanced Micro Processor Based CATV Status Monitor System", E.S. Walker and T.M. Alldread).

On the other hand, FIG. 18 shows the inside of the trunk amplifier 1605, in which the frequency division multiplexing filters 1801, 1807 are same as the filter 1704 shown in FIG. 17. The down line amplifier 1803 and up line amplifier 1811 are for compensating the frequency characteristic and attenuation of the coaxial line. The splitter 1804 and distortion detecting part 1806 are same as the splitter 105 and distortion detecting part 106 in FIG. 1. Numeral 1802 is a splitter and 1810 is a combining network, and the reception demodulation circuit 1805 responds to the send-out signal of transmission modulation circuit 1707, while, similarly, the send-out signal of transmission modulation circuit 1808 responds to the reception demodulation circuit 1708. The control circuit 1809 exchanges commands with the CPU control circuit 1709 by using transmission modulation circuits 1707, 1808, reception demodulation circuits 1708, 1805, combining network 1810, 1703, and splitters 1706, 1802, and transmits the trouble detection information from the distortion detecting part 1806 to the surveillance terminal 1713.

The distortion surveillance apparatus in thus constructed first embodiment of this invention can accurately detect the trouble due to distortion increase of the transmission system, by detecting the level of a signal of horizontal scanning frequency or its higher harmonic component, out of the cross modulation components from the transmitted television signal to the pilot signal, and judging it abnormal by the elevation of this level.

FIG. 19 is a block diagram showing a construction of distortion surveillance apparatus in a second embodiment of this invention.

numeral 1901 is an input terminal, 1903 is a combining network, 1902 is a pilot signal generator, 1904 is a transmission system A, 1905 is an attenuator, 1906 is a transmission system B, 1907 is a splitter, 1908 is a distortion detection control part, and 1909 is an output terminal. The input terminal 1901, combining network 1903, pilot signal generator 1902, splitter 1907, and output terminal 1909 are exactly the same as those in the first embodiment, that is, input terminal 101, combining network 103, pilot signal generator 102, splitter 105, and output terminal 107 in FIG. 1. What is different from the first embodiment is that an attenuator 1905 is inserted on the way of transmission system 104 to divide into the preceding portion of transmission system 104 as transmission system A 1904 and the succeeding portion as transmission system B 1906. In a special case incidentally, transmission system A 1904 or transmission system B 1906 may be omitted. Besides, the distortion detection control part 1908 which produces a signal to control the attenuator 1905 and detects distortion is slightly different from the distortion detecting part 106.

Details of the attenuator 1905 and distortion detection control part 1908 are described below.

As the attenuator 1905, a wide band variable attenuator using PIN diodes is employed. Its circuit example is shown in FIG. 20, in which numerals 2001, 2006, 2009, 2011, 2007, 2013 are capacitors for bypass ; 2008, 2012 are resistors for bias ; 2003, 2004 are resistors equal to the line impedance ; 2010 is a choke coil for cutting off high frequency signals ; 2014 is a load resistor of control signal ; 2015 is a three-terminal regulator for obtaining a referene voltage lower than the supply voltage so as to apply also reverse bias to the PIN diodes ; and 2002, 2005 are PIN diodes.

The internal structure of the distortion detection control part 1908 is similar to that of the first embodiment, that is, the construction shown in FIG. 3, except that the internal structure of the pilot signal extraction rectifier 301 is slightly different. The internal structure of pilot signal extraction rectifier 301 was intended, in the first embodiment, to keep constant the pilot signal carrier level by varying the amplitude of the pilot signal amplifier 402, intermediate frequency amplifier 805, in FIG. 4 or FIG. 8, by using the direct-current component of output signal of rectifier 403 or 806. In the second embodiment, the pilot signal carrier level is kept constant by varying the attenuation of the attenuator 1905. FIG. 21 or FIG. 22 shows an internal construction of pilot signal extraction rectifier 301 in the second embodiment. As mentioned above, the pilot signal extraction filter 2101, rectifier 2103, first filter 2201, frequency converter 2202, local oscillator 2203, second filter 2204, and rectifier 2206 are identical with the pilot signal extraction filter 401, rectifier 403, first filter 801, frequency converter 802, local oscillator 803, second filter 804, and rectifier 806 in FIG. 4 or FIG. 8. What is different is that the amplitude of pilot signal amplifier 2102 and intermediate frequency amplifier 2204 is constant.

FIG. 23 shows an example of circuit diagram of pilot signal amplifier 2102 and rectifier 2103 or intermediate frequency amplifier 2205 and rectifier 2206. Numerals 2302, 2303, 2305, 2311, 2313, 2314 are resistors for bias ; 2301, 2306, 2313, 2315 are capacitors for bypass ; 2307 and 2310, 2316 and 2320 are respectively resistors and capacitors for power source decoupling ; 2308 and 2309, 2317 and 2318 are respectively capacitors and coils of resonance circuits which resonate to the pilot signal frequency or intermediate frequency ; and 2304 and 2319 are transistors-these components are combined to make up the pilot signal amplifier 2102 or intermediate frequency amplifier 2205. Rectifier 2103 or 2206 of half-wave rectifying type is composed of diode 2321 and smoothing circuits 2322, 2323, 2324. The direct-current component of the output of the rectifier picked up by the filter composed of resistor 2325 and capacitor 2326 is amplified by the transistor 2327 to become a control signal to the attenuator 1905. Meanwhile, the rectifiers 2103, 2206 may be replaced by synchronous rectifier as shown in the first embodiment.

The distortion surveillance apparatus in thus composed second embodiment of this invention can accurately detect the trouble due to distortion increase in the transmission system as in the first embodiment, and in FIG. 19 the function to keep an optimum level of the output of transmission system B 1906 or output terminal 1909 is realized by sharing almost all of the block for distortion detection. Meanwhile, as an example, a construction of trunk amplifier 1605 having the splitter 1907 and distortion detection control part 1908 placed at the position of trunk amplifier 1605 in FIG. 16 is shown in FIG. 24. The frequency division multiplexing filters 2401, 2407, splitter 2402, down line amplifier 2403, up line amplifier 2411, combining network 2410, reception demodulation circuit 2405, transmission modulation circuit 2408, and control circuit 2409 are same as in the construction in FIG. 18. The attenuator 2412, splitter 2404, distortion detection control part 2406, and down line amplifier 2403 respectively correspond to the attenuator 1905, splitter 1907, distortion detection control part 1908, and transmission system B 1906 in FIG. 19.

FIG. 25 is a block diagram showing-an internal structure of a trunk amplifier installed in the distortion surveillance apparatus in a third embodiment of this invention. This trunk amplifier is fashioned after the trunk amplifier 1605 in FIG. 16.

In FIG. 25, numerals 2501, 2507 are frequency division multiplexing filters ; 2502, 2504 are splitters ; 2503 is a down line amplifier ; 2506 is a distortion detecting part ; 2505 is a reception demodulation circuit; 2508 is a transmission modulation circuit ; 2509 is a control circuit ; 2510 is a combining network ; and 2511 is an up transmission amplifier, which are all identical with those in FIG. 18 as an example of the first embodiment. In this embodiment, what is different is that a pilot signal generated in the pilot signal generator 2513 is injected by placing a combining network 2512 between the frequency division multiplexing filter 2501 and down line amplifier 2503.

FIG. 26 shows an example of circuit diagram of frequency division multiplexing filter 2501 or 2507. Capacitors 2601, 2602, 2603, 2604, and coils 2605, 2606, 2607, 2608, 2609, 2610, 2611 made up an eight-element elliptical function high-pass filter. In the CATV coaxial cable transmission system, the high range side is used for down transmission and the low range side for up transmission, and this highpass filter allows to pass down transmission signals and cuts off up transmission signals. On the other hand, coils 2612, 2613, 2614, 2615, and capacitors 2616, 2617, 2618, 2619, 2620, 2621, 2622 make up an eight-element elliptical function low-pass filter, which allows to pass up transmission signals and cuts off down transmission signals. In the CATV coaxial cable transmission system, the upper end of up transmission signal band and lower end of down transmission signal band are determined mainly by these filters. In the transient interval between the passing range and cut-off range of these filters, since the group delay characteristic and other properties are not excellent, there is a frequency region not used in either up or down transmission, called guard band, between the up transmission band and down transmission band.

If the pilot signal feed point, that is, the combining network 2512, is placed ahead of the frequency division multiplexing filter 2501, it was necessary to select the pilot signal frequency within the transmission band so that the pilot signal could pass through this filter. But in this third embodiment, the upper or lower side region may be used in an operating range of down line amplifier 2503. In particular, within the guard band, since there is no other transmission signals, the frequency of the desired transmission signal is not consumed by the pilot signal, or it is easier to extract the pilot signal because there are no signals close thereto. This explanation related to the example of down transmission, and the same holds true with the up transmission if television signals are contained in the up transmission.

## Claims

1. A distortion surveillance apparatus used in a transmission system for signals including a television signal, comprising :

means (102) coupled to a first specified position in said transmission system for supplying a pilot signal to said transmission system ;

first extraction means (105, 2101) coupled to a second specified position in said transmission system for extracting said pilot signal which has been subjected to a cross modulation with said television signal via a nonlinearity of said transmission system between said first and second specified positions ;

rectifying means (301, 801-806, 2103, 2106) for obtaining an envelope of said cross modulated pilot signal from an output signal of said first extraction means ;

second extraction means (302) for extracting from said envelope at least a signal component of a horizontal scanning frequency of the television signal and its harmonic components ;

level detection means (303, 1401-1433) for detecting a level of a signal extracted by said second extraction means ; and

judging means (304) for producing a signal indicating an occurrence of abnormal signal distortion increase when void level detected by said level detection means becomes abnormally large.

2. The apparatus as set forth in Claim 1, wherein said first extraction means comprises a pilot signal extraction filter (401) which allows to pass a pilot signal frequency.

3. The apparatus as set forth in Claim 1, wherein said first extraction means comprises a first filter (801) to attenuate an image frequency of the pilot signal frequency, a frequency converter to convert an output signal of said first filter to a corresponding intermediate frequency band, a local oscillator (803) to supply a corresponding local oscillation signal to said frequency converter, and a second filter (804) which allows to pass said pilot signal converted to said intermediate frequency band.

4. The apparatus as set forth in Claim 3, wherein said frequency converter is a double balanced mixer (901-906).

5. The apparatus as set forth in Claim 1, further comprising means (628-631) to keep constant the level of said cross modulated pilot signal, which controls a gain of an amplifier (402) to amplifiy said cross modulated pilot signal by using a direct-current component of the output signal of said rectifying means (403).

6. The apparatus as set forth in Claim 1, further comprising means (2325-2327) to keep constant the level of said cross modulated pilot signal, which controls an attenuation of an attenuator (1905) installed in said transmission system between said first and second specified positions by using a direct current component of the output signal of said rectifying means (2103, 206).

7. The apparatus as set forth in Claim 6, wherein said attenuator comprises PIN diodes (2202, 2005).

8. The apparatus as set forth in Claim 1, wherein said rectifying means comprises an envelope detector using diodes (624, 2321).

9. The apparatus as set forth in Claim 1, wherein said rectifying means comprises a synchronous rectifier.

10. The apparatus as set forth in Claim 1, wherein said second extraction means extracts the fundamental wave component of the horizontal scanning frequency of said television signal.

11. The apparatus as set forth in Claim 1, wherein said second extraction means extracts the harmonic components of the horizontal scanning frequency of said television signal.

12. The apparatus as set forth in Claim 1, wherein said second extraction means comprises a three-terminal tuning fork type crystal filter.

13. The apparatus as set forth in Claim 1, wherein said second extraction means comprises a three-terminal mechanical filter.

14. The apparatus as set forth in Claim 1, weherein said second extraction means comprises a ceramic filter.

15. The apparatus as set forth in Claim 1, wherein said second extraction means comprises a crystal filter comprising two-terminal tuning fork type crystal oscillators.

16. The apparatus as set forth in Claim 15, wherein said crystal filter has a structure in which said tuning fork type crystal oscillators are arranged in series and capacitors are arranged in parallel.

17. The apparatus as set forth in Claim 15, wherein said crystal filter has a structure in which said tuning fork type crystal oscillators are arranged in parallel and capacitors are arranged in series.

18. The apparatus as set forth in Claim 15, wherein said crystal filter has a structure in which said tuning fork type crystal oscillators are arranged in series and parallel.

19. The apparatus as set forth in Claim 1, wherein said judging means (304) comprises a switching circuit (1501-1507) having a hysteresis characteristic at a threshold level to judge whether said level is normal or abnormal.

20. The apparatus as set forth in Claim 1, wherein said transmission system is a CATV transmission system.

21. The apparatus as set forth in Claim 20, comprising frequency division multiplexing filters (2501, 2507) arranged such that no frequency division multiplexing filter is installed between said first and second specified positions.

22. The apparatus as set forth in Claim 21, wherein the frequency of said pilot signal is out of a transmission frequency band determined by said frequency division multiplexing filter.

## Ansprüche

1. Überwachungsgerät für Verzerrungen, das in einem Übertragungssystem für Signale einschließlich eines Fernsehsignals benutzt wird,

mit einem Hilfsmittel (102), das an einer ersten vorgeschriebenen Position des Übertragungssystems zwecks Zuführung eines Überwachungssignals in das Übertragungssytem angeschlossen ist,

mit einer Abziehvorrichtung (105, 2101), die an einer zweiten vorgeschriebenen Position des Übertragungssystems zwecks herausziehen des Überwachungssignals angeschlossen ist, das durch eine Nichtlinearität des Übertragungssystems zwischen der ersten und zweiten vorgeschriebenen Position einer Kreuzmodulation mit dem Fernsehsignal unterworfen worden ist,

mit Gleichrichtern (301, 801 bis 806, 2103, 2106), über die von einem aus der Abziehvorrichtung austretenden Signal eine hüllkurve des kreuzmodulierten Überwachungssignals erhalten wird,

mit einer zweiten Abziehvorrichtung (302), von der aus der hüllkurve mindestens eine Signalkomponente einer horizontalen Abtastfrequenz des Fernsehsignals und ihre harmonischen herausgezogen wird,

mit Niveau-Detektoren (303, 1401 bis 1433) zur Wahrnehmung eines Signalniveaus, das von der zweiten Abziehvorrichtung herausgezogen ist, und

mit einer Prüfschaltung (304) zwecks Erzeugung eines Signals, das eine abnormale Zunahme der Signalverzerrung anzeigt, wenn das von den Niveau-Detektoren wahrgenommene Niveau übermäßig groß wird.

2. Gerät, wie im Anspruch 1 dargelegt, bei dem die erste Abziehvorrichtung ein Extraktionsfilter (401) für das Überwachungssignal enthält, das eine Frequenz des Überwachungssignals hindurchgehen läßt.

3. Gerät, wie im Anspruch 1 dargelegt, bei dem die erste Abziehvorrichtung ein erstes Filter (801) zur Dämpfung einer Bildfrequenz aus der Frequenz des Überwachungssignals, einen Frequenzwandler zur Ümwandlung des vom ersten Filter abgegebenen Signals in ein passendes Zwischenfrequenzband, einen örtlichen Oszillator (803) zwecks Zuführung eines entsprechenden, örtlichen Schwingungssignals zu dem Frequenzwandler und ein zweites Filter (804) enthält, das das Überwachungssignal hindurchgehen läßt, das in das Zwischerfrequenzband umgewandelt ist.

4. Gerät, wie im Anspruch 3 dargelegt, bei dem der Frequenzwandler ein abgeglichener, doppelter Mischer (901 bis 906) ist.

5. Gerät, wie im Anspruch 1 dargelegt, ferner mit Hilfsmitteln (628 bis 631), die das Niveau des kreuzmodulierten Uberwachungssignals konstant halten,von dem der Verstärkungsgrad eines Verstärkers (402) beeinflußt wird, um unter Verwendung einer Gleichstromkomponente des von dem Gleichrichter (403) abgegebenen Signals das kreuzmodulierte Überwachunassignal zu verstärken.

6. Gerät, wie im Anspruch 1 dargelegt, ferner mit Hilfsmitteln (2325 bis 2327), mittels deren das Niveau des kreuzmodulierten Überwachungssignals konstant gehalten wird, von dem die Dämpfung eines Dämpfungsgliedes (1905) gesteuert wird, das in dem Übertragungssystem zwischen den beiden vorgeschriebenen Positionen angeordnet ist, wobei eine Gleichstromkomponente des von den Gleichrichtern (2103, 2106) abgegebenen Signals benutzt wird.

7. Gerät, wie im Anspruch 6 dargelegt, bei dem das Dämpfungsglied pin-Dioden (2002, 2005) enthält.

8. Gerät, wie im Anspruch 1 dargelegt, bei dem die Gleichrichter einen Detektor für die Hüllkurve enthalten, von dem Dioden (624, 2321) verwendet werden.

9. Gerät, wie im Anspruch 1 dargelegt, bei dem zu den Gleichrichtern ein synchroner Gleichrichter gehört.

10. Gerät, wie im Anspruch 1 dargelegt, bei dem die zweite Abziehvorrichtung die Grundkomponente der horizontalen Abtastfrequenz des Fernsehsignals herauszieht.

11. Gerät, wie im Anspruch 1 dargelegt, bei dem die zweite Abziehvorrichtung die Harmonischen der horizontalen Abtastfrequenz des Fernsehsignals herauszieht.

12. Gerät, wie im Anspruch 1 dargelegt, bei dem die zweite Abziehvorrichtung ein Kristallfilter nach Art einer dreiendigen Abstimmgabel enthält.

13. Gerät, wie im Anspruch 1 dargelegt, bei dem die zweite Abziehvorichtung ein elektromechanisches Filter mit drei Anschlüssen enthält.

14. Gerät, wie im Anspruch 1 dargelegt, bei dem die zweite Abziehvorrichtung ein keramisches Filter aufweist.

15. Gerät, wie im Anspruch 1 dargelegt, bei dem die zweite Abziehvorrichtung ein Kristallfilter mit Kristalloszillatoren nach Art einer zweiendigen Stimmgabel enthält.

16. Gerät, wie im Anspruch 15 dargelegt, bei dem das Kristallfilter eine Konstruktion besitzt, bei der die Kristalloszillatoren nach Art einer Stimmgabel in Reihe und Kondensatoren parallel angeordnet sind.

17. Gerät, wie im Anspruch 15 dargelegt, bei dem das Kristallfilter eine Konstruktion besitzt, bei der die Kristalloszillatoren nach Art einer Stimmgabel parallel und die Kondensatoren in Reihe angeordnet sind.

18. Gerät, wie im Anspruch 15 dargelegt, bei dem das Kristallfilter eine Konstruktion besitzt, bei der die kristalloszillatoren nach Art einer Stimmgabel in Reihe und parallel angeordnet sind.

19. Gerät, wie im Anspruch 1 dargelegt, bei dem die Prüfschaltung (304) Schaltmittel (1501, 1507) enthält, die bei einem Schwellenwert eine Hysterese zeigen, um zu entscheiden, ob das Niveau normal oder abnormal ist.

20. Gerät, wie im Ansprurh 1 dargelegt, bei dem das Übertragungssystem ein Kabelfernseh-Übertragungssystem ist.

21. Gerät, wie im Anspruch 20 dargelegt, bei dem FrequenzteilungsMultiplexfilter (2507) so eingebaut sind,daß keines von ihnen zwischen den beiden vorgeschriebenen Positionen eingebaut ist.

22. Gerät, wie im Anspruch 21 dargelegt, bei dem die Frequenz des Über wachungssignals außerhalb eines Frequenzbandes liegt, das durch das Frequenzteilungs-Multiplexfilter bestimmt wird.

## Revendications

1. Un dispositif de surveillance de distorsion utilisé dans un système de transmission pour des signaux comprenant un signal de télévision, comprenant :

des moyens (102) connectés à une première position spécifiée dans le système de transmission pour appliquer un signal pilote au système de transmission ;

des premiers moyens d'extraction (105, 2101) connectés à une seconde position spécifiée dans le système de transmission, pour extraire le signal pilote qui a été soumis à une transmodulation par le signal de télévision, sous l'effet d'une non-linéarité du système de transmission entre les première et seconde positions spécifiées ;

des moyens de redressement (301, 801-806, 2103, 2106) pour obtenir un enveloppe du signal pilote transmodulé, à partir d'un signal de sortie des premiers moyens d'extraction ;

des seconds moyens d'extraction (302) pour extraire de l'enveloppe au moins une composante de signal correspondant à une fréquence de balayage horizontal du signal de télévision et à ses composantes harmoniques ;

des moyens de détection de niveau (303, 1401-1433) pour détecter le niveau d'un signal qui est extrait par les seconds moyens d'extraction ; et

des moyens de décision (304) pour produire un signal indiquant l'apparition d'une augmentation anormale de la distorsion de signal lorsque le niveau que détectent les moyens de détection de niveau devient anormalement élevé.

2. Le dispositif selon la revendication 1, dans lequel les premiers moyens d'extraction comprennent un filtre d'extraction de signal pilote (401) qui laisse passer une fréquence de signal pilote.

3. Le dispositif selon la revendication 1, dans lequel les premiers moyens d'extraction comprennent un premier filtre (801) pour atténuer une fréquence image de la fréquence du signal pilote, un convertisseur de fréquence pour convertir un signal de sortie du premier filtre pour le placer dans une bande de fréquence intermédiaire correspondante, un oscillateur local (803) pour appliquer un signal d'oscillation locale correspondant au convertisseur de fréquence, et un second filtre (804) qui laisse passer le signal pilote converti dans la bande de fréquence intermédiaire.

4. Le dispositif selon la revendication 3, dans lequel le convertisseur de fréquence est un mélangeur doublement équilibré (901-906).

5. Le dispositif selon la revendication 1, comprenant en outre des moyens (628-631) pour maintenir constant le niveau du signal pilote transmodulé, qui commandent le gain d'un amplificateur (402) destiné à amplifier le signal pilote transmodulé, en utilisant une composante à courant continu du signal de sortie des moyens de redressement (403).

6. Le dispositif selon la revendication 1, comprenant en outre des moyens (2325-2327) destinés à maintenir constant le niveau du signal pilote transmodulé, qui commandent l'atténuation d'un atténuateur (1905) installé dans le système de transmission entre les première et seconde positions spécifiées, en utilisant une composante à courant continu du signal de sortie des moyens de redressement (2103, 2106).

7. Le dispositif selon la revendication 6, dans lequel l'atténuateur est constitué par des diodes PIN (2002, 2205).

8. Le dispositif selon la revendication 1, dans lequel les moyens de redressement sont constitués par un détecteur d'enveloppe utilisant des diodes (624, 2321).

9. Le dispositif selon la revendication 1, dans lequel les moyens de redressement sont constitués par un redresseur synchrone.

10. Le dispositif selon la revendication 1, dans lequel les seconds moyens d'extraction extraient la composante d'onde fondamentale de la fréquence de balayage horizontal du signal de télévision.

11. Le dispositif selon la revendication 1, dans lequel les seconds moyens d'extraction extraient les composantes harmoniques de la fréquence de balayage horizontal du signal de télévision.

12. Le dispositif selon la revendication 1, dans lequel les seconds moyens d'extraction sont constitués par un filtre à quartz du type diapason à trois bornes.

13. Le dispositif selon la revendication 1, dans lequel les seconds moyens d'extraction sont constitués par un filtre mécanique à trois bornes.

14. Le dispositif selon la revendication 1, dans lequel les seconds moyens d'extraction sont constitués par un filtre à céramique.

15. Le dispositif selon la revendication 1, dans lequel les seconds moyens d'extraction sont constitués par un filtre à quartz comprenant des oscillateurs à quartz du type diapason à deux bornes.

16. Le dispositif selon la revendication 15, dans lequel le filtre à quartz a une structure dans laquelle les oscillateurs à quartz du type diapason sont disposés en série et des condensateurs sont disposés en parallèle.

17. Le dispositif selon la revendication 15, dans lequel le filtre à quartz a une structure dans laquelle les oscillateurs à quartz du type diapason sont disposés en parallèle et des condensateurs sont disposés en série.

18. Le dispositif selon la revendication 15, dans lequel le filtre à quartz a une structure dans laquelle les oscillateurs à quartz du type diapason sont disposés en série et en parallèle.

19. Le dispositif selon la revendication 1, dans lequel les moyens de décision (304) comprennent un circuit de commutation (1501-1507) ayant une caractéristique d'hystérésis à un niveau de seuil, pour décider si le niveau est normal ou anormal.

20. Le dispositif selon la revendication 1, dans lequel le système de transmission est un système de transmission de télévision par câble.

21. Le dispositif selon la revendication 20, comprenant des filtres de multiplexage par répartition en fréquence (2407, 2507) qui sont disposés de façon qu'aucun filtre de multiplexage par répartition en fréquence ne soit installé entre les première et seconde positions spécifiées.

22. Le dispositif selon la revendication 21, dans lequel la fréquence du signal pilote est à l'extérieur d'une bande de fréquence de transmission qui est déterminée par le filtre de multiplexage par répartition en fréquence.

FIG. 1

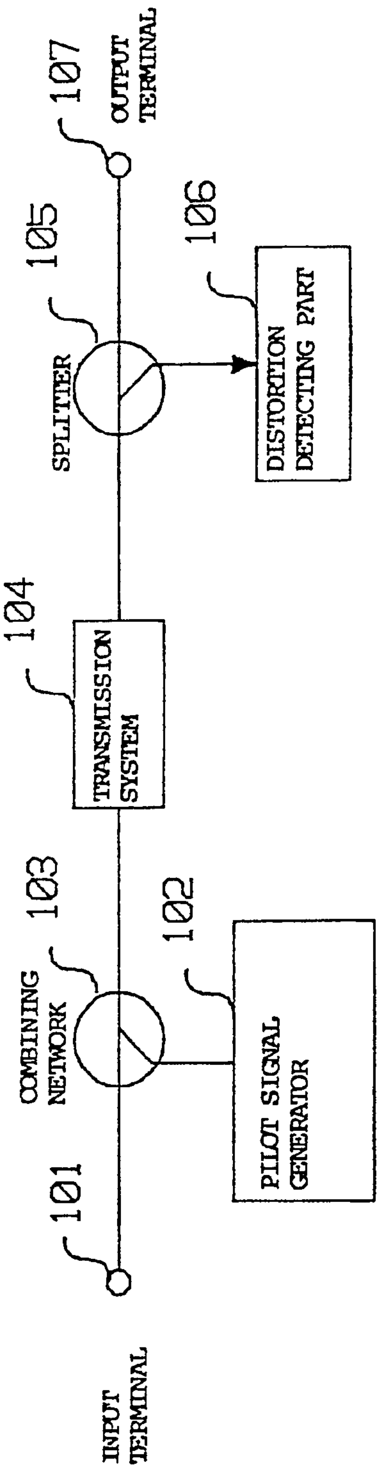
101
INPUT TERMINAL
102
PILOT SIGNAL GENERATOR
103
COMBINING NETWORK
104
TRANSMISSION SYSTEM
105
SPLITTER
106
DISTORTION DETECTING PART
107
OUTPUT TERMINAL

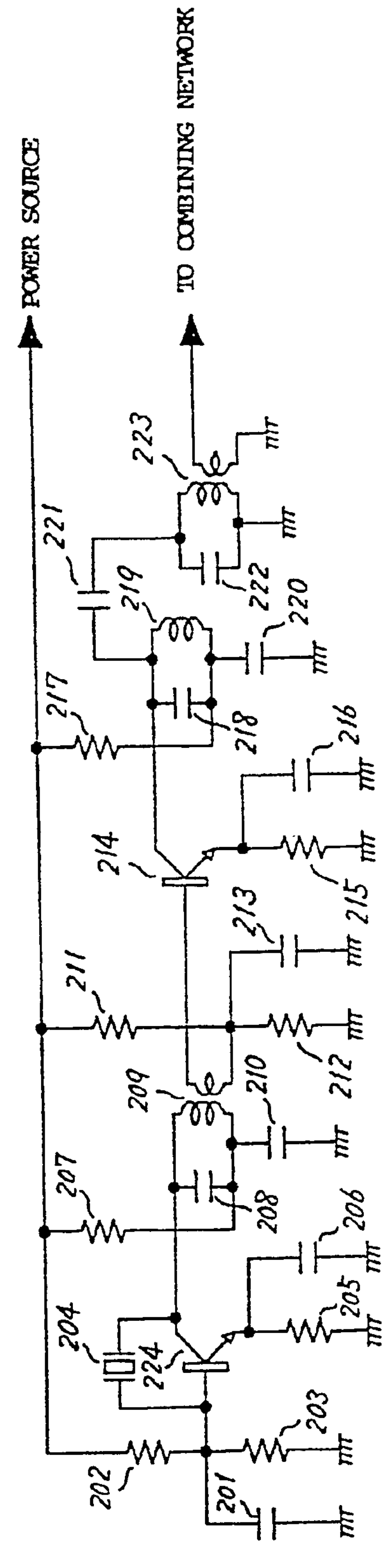
POWER SOURCE
TO COMBINING NETWORK
201
202
203
204
205
206
207
208
209
210
211
212
213
214
215
216
217
218
219
220
221
222
223
224

FIG. 2

FIG. 3

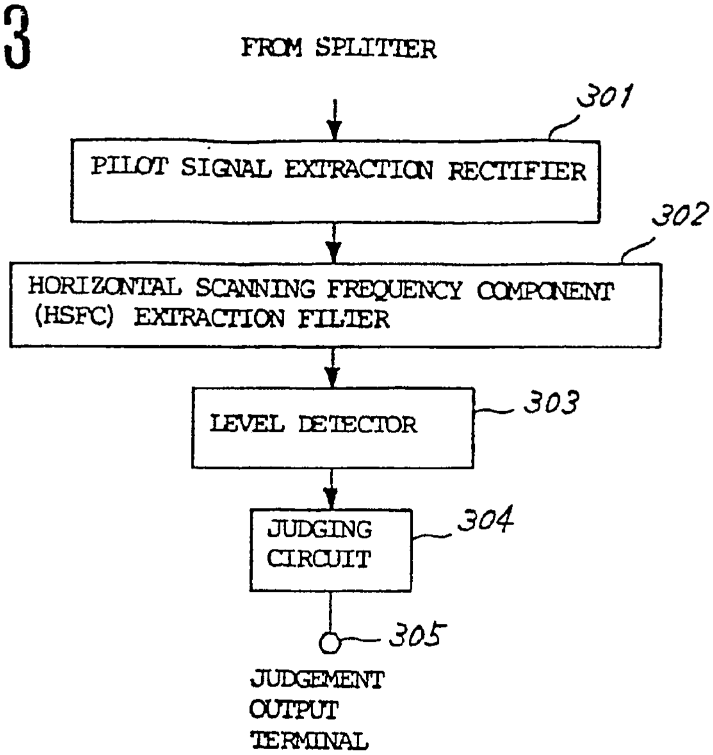
FROM SPLITTER
301
PILOT SIGNAL EXTRACTION RECTIFIER
302
HORIZONTAL SCANNING FREQUENCY COMPONENT
(HSFC) EXTRACTION FILTER
LEVEL DETECTOR
303
JUDGING
CIRCUIT
304
305
JUDGEMENT
OUTPUT
TERMINAL

FIG. 4

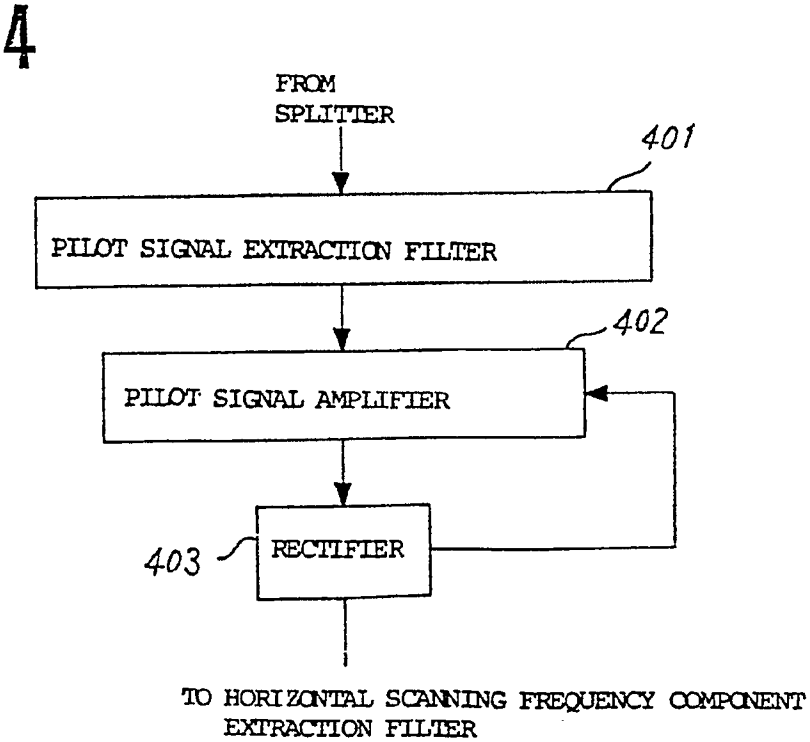
FROM
SPLITTER
401
PILOT SIGNAL EXTRACTION FILTER
402
PILOT SIGNAL AMPLIFIER
403
RECTIFIER
TO HORIZONTAL SCANNING FREQUENCY COMPONENT
EXTRACTION FILTER

FIG. 5

(a) Distortion detecting part input signal spectra

(b) Frequency characteristic of pilot signal extraction filter

(c) Extracted pilot signal and its sidebands

(d) Spectra after envelope detection

(e) An example of frequency characteristic of HSFC extraction filter

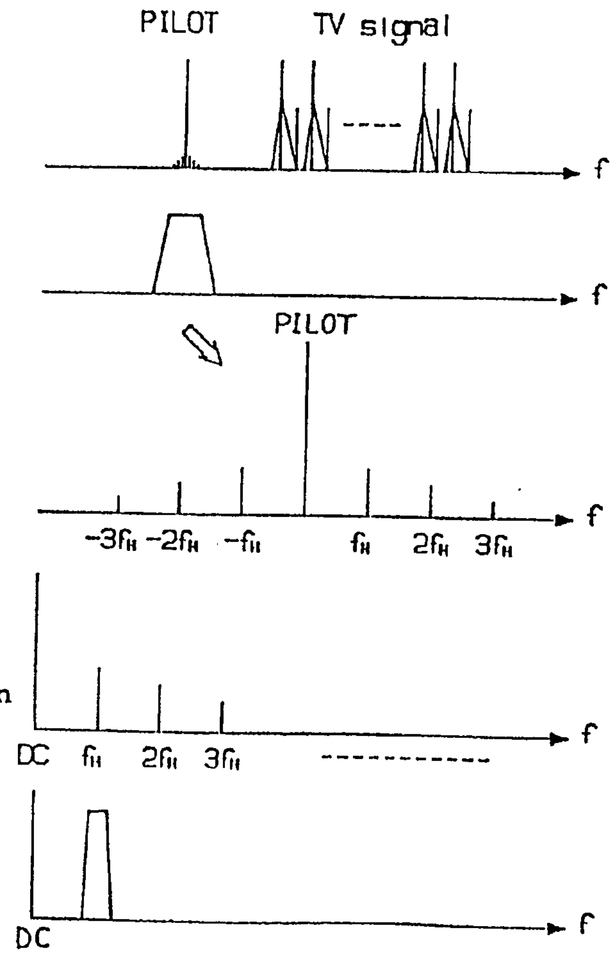

FIG. 6

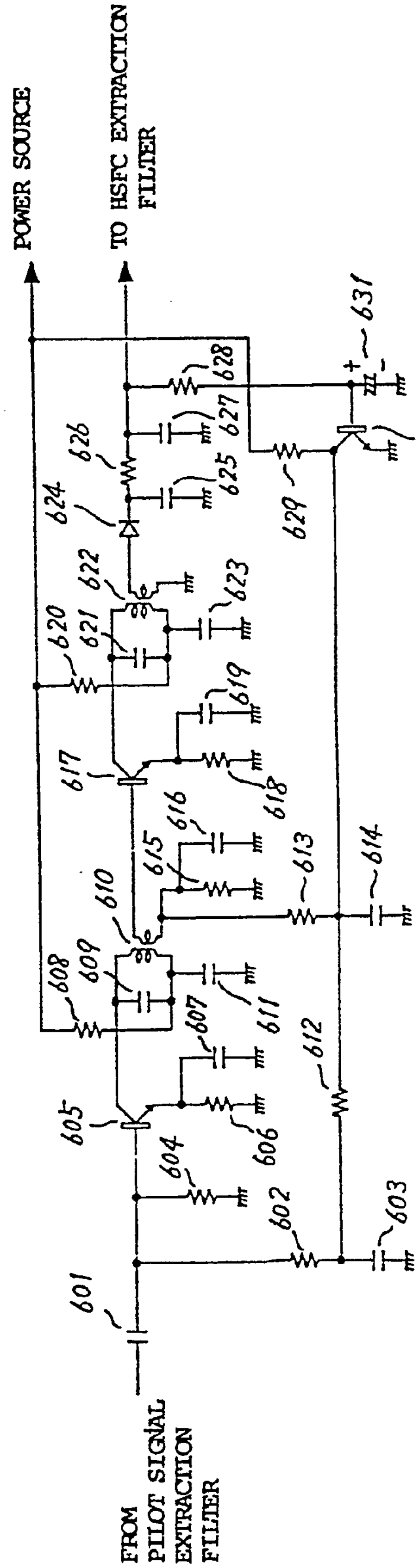
POWER SOURCE
TO HSFC EXTRACTION FILTER
FROM PILOT SIGNAL EXTRACTION FILTER
601
602
603
604
605
606
607
608
609
610
611
612
613
614
615
616
617
618
619
620
621
622
623
624
625
626
627
628
629
630
631
+
-

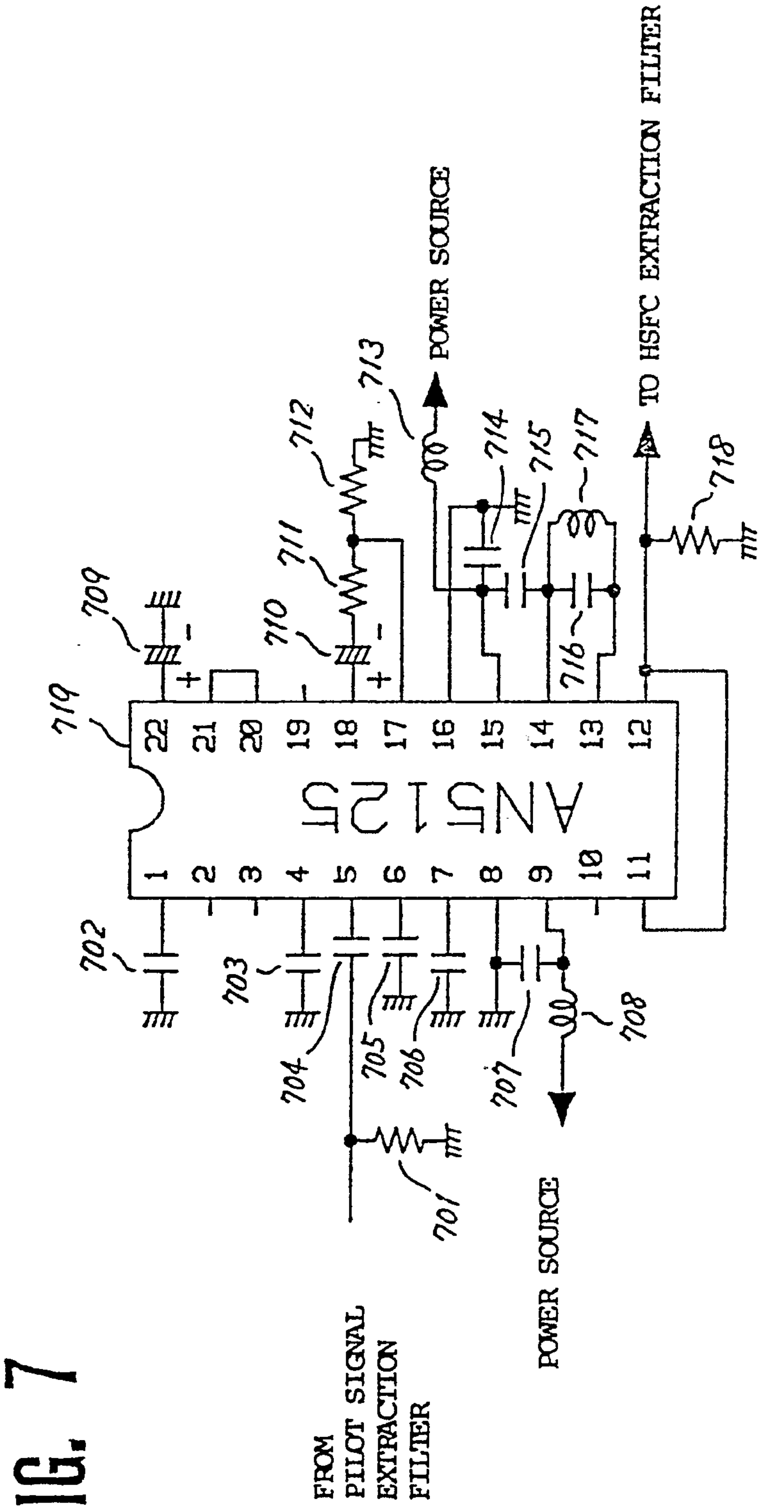
FROM
PILOT SIGNAL
EXTRACTION
FILTER
POWER SOURCE
POWER SOURCE
TO HSFC EXTRACTION FILTER
AN5125
701
702
703
704
705
706
707
708
709
710
711
712
713
714
715
716
717
718
719

FIG. 7

FIG. 8

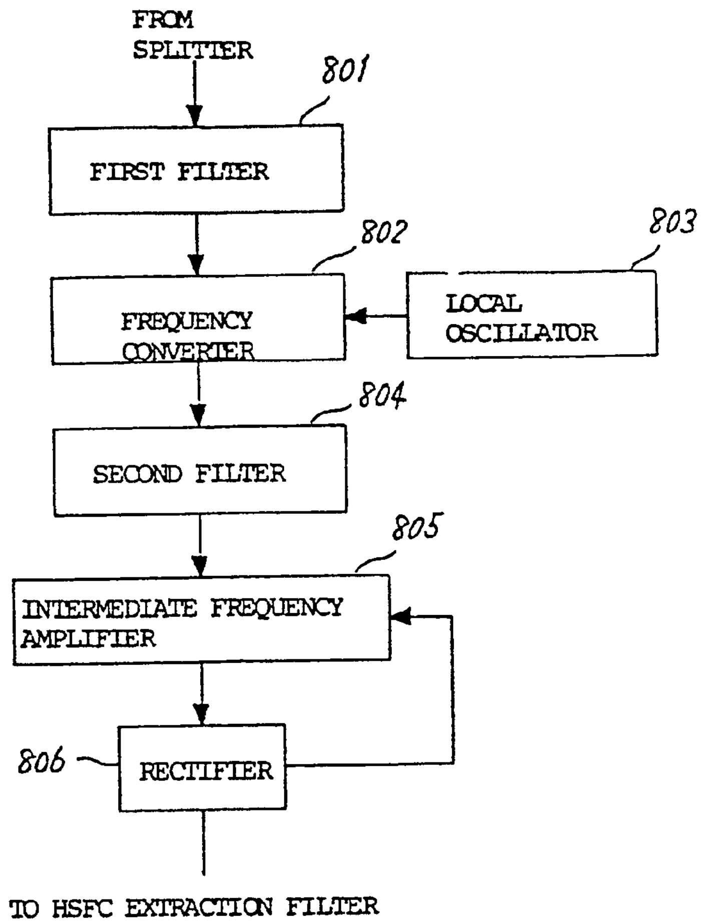
FROM SPLITTER
801
FIRST FILTER
802
803
FREQUENCY CONVERTER
LOCAL OSCILLATOR
804
SECOND FILTER
805
INTERMEDIATE FREQUENCY AMPLIFIER
806
RECTIFIER
TO HSFC EXTRACTION FILTER

FIG. 9

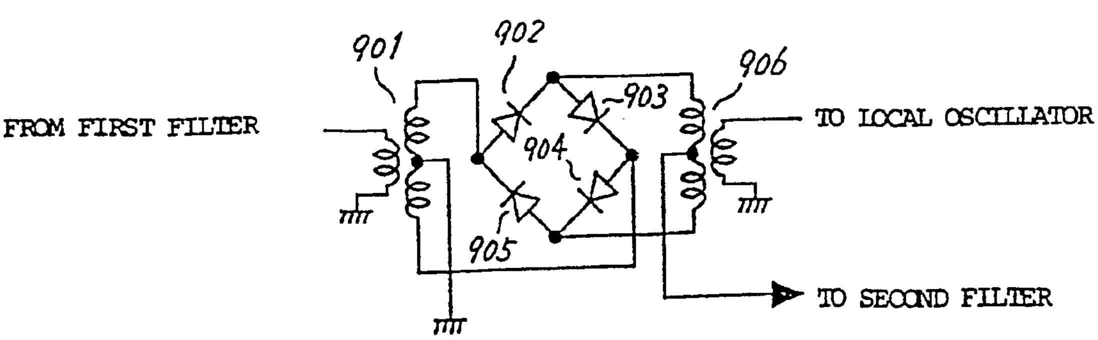
FROM FIRST FILTER
901
902
903
904
905
906
TO LOCAL OSCILLATOR
TO SECOND FILTER

FIG. 10

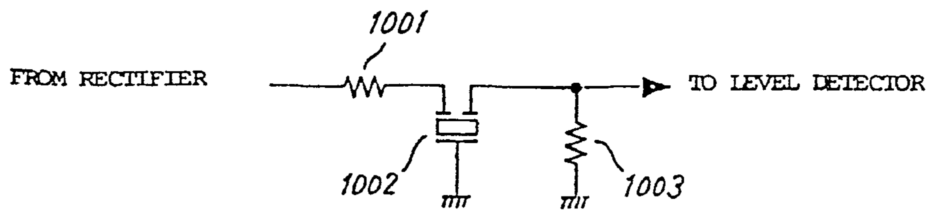


FIG. 11

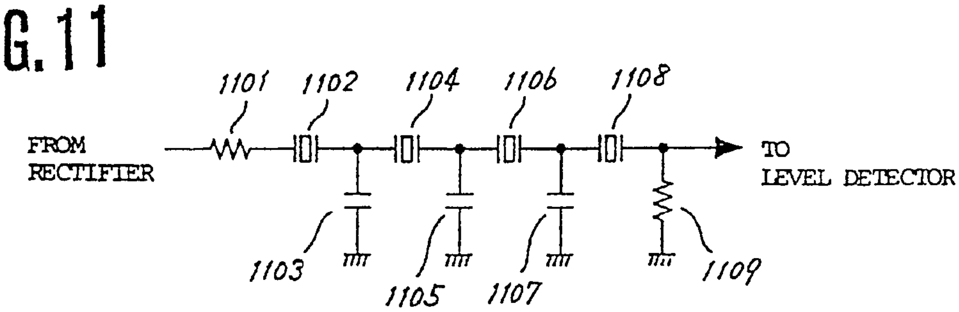


FIG. 12

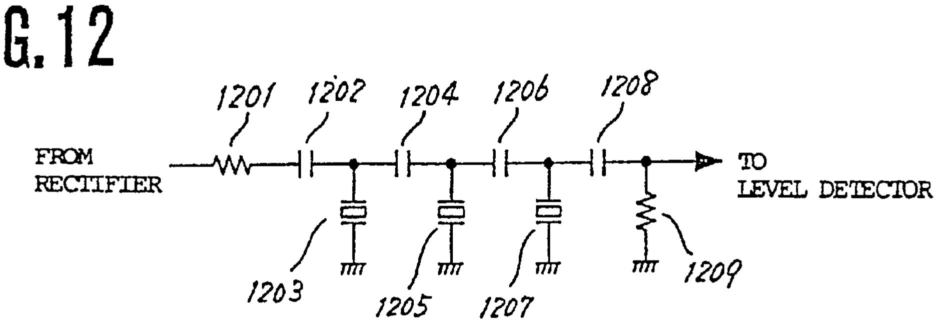


FIG. 13

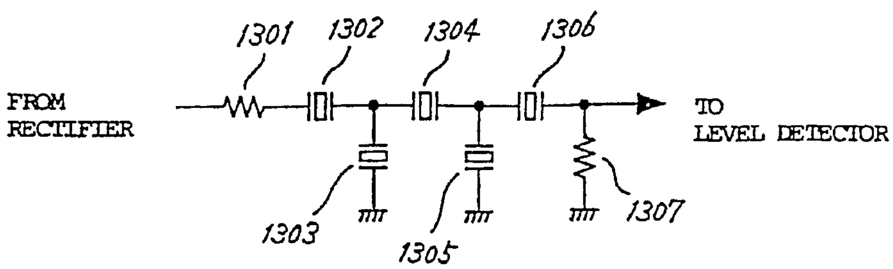

FIG. 14

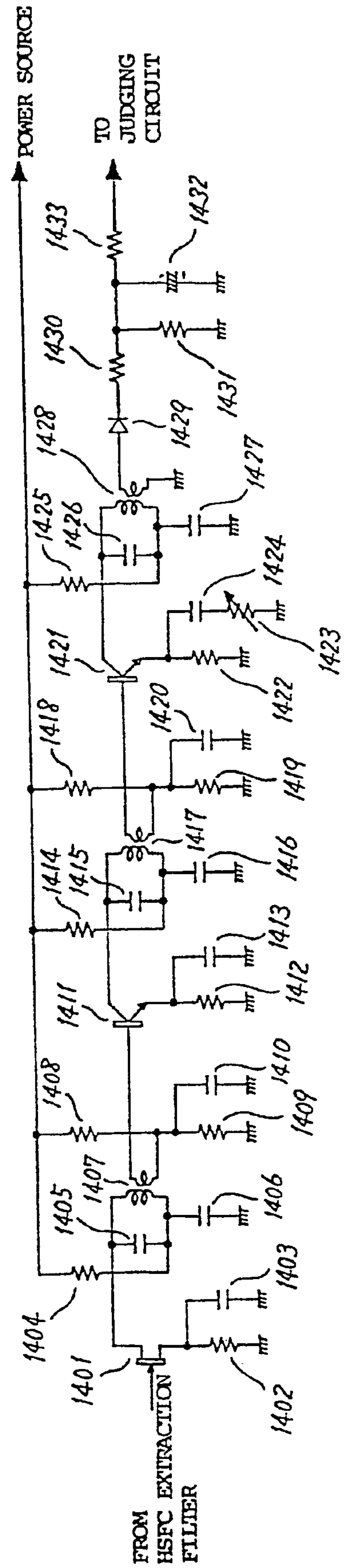
POWER SOURCE
TO JUDGING CIRCUIT
FROM HSFC EXTRACTION FILTER
1401
1402
1403
1404
1405
1406
1407
1408
1409
1410
1411
1412
1413
1414
1415
1416
1417
1418
1419
1420
1421
1422
1423
1424
1425
1426
1427
1428
1429
1430
1431
1432
1433

FIG.15

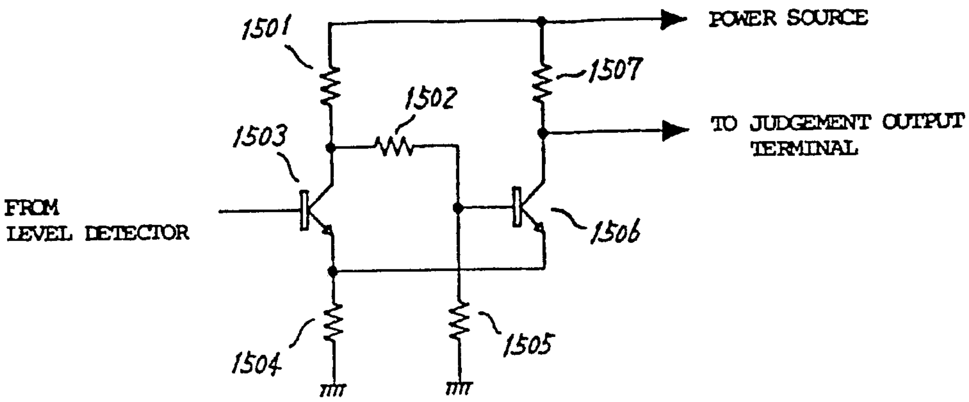
1501
1502
1503
1504
1505
1506
1507
POWER SOURCE
TO JUDGEMENT OUTPUT TERMINAL
FROM LEVEL DETECTOR

FIG.26

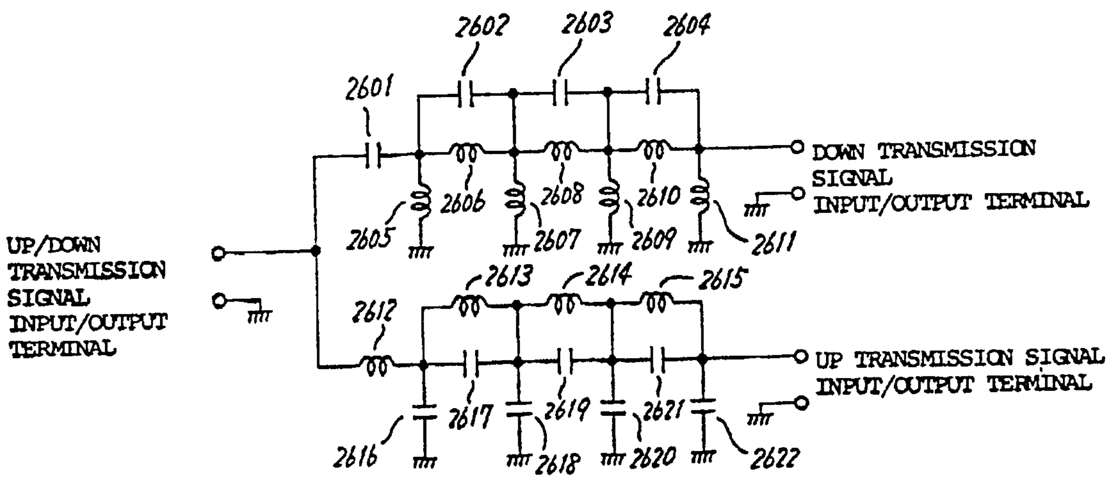
2601
2602
2603
2604
2605
2606
2607
2608
2609
2610
2611
2612
2613
2614
2615
2616
2617
2618
2619
2620
2621
2622
DOWN TRANSMISSION SIGNAL INPUT/OUTPUT TERMINAL
UP/DOWN TRANSMISSION SIGNAL INPUT/OUTPUT TERMINAL
UP TRANSMISSION SIGNAL INPUT/OUTPUT TERMINAL

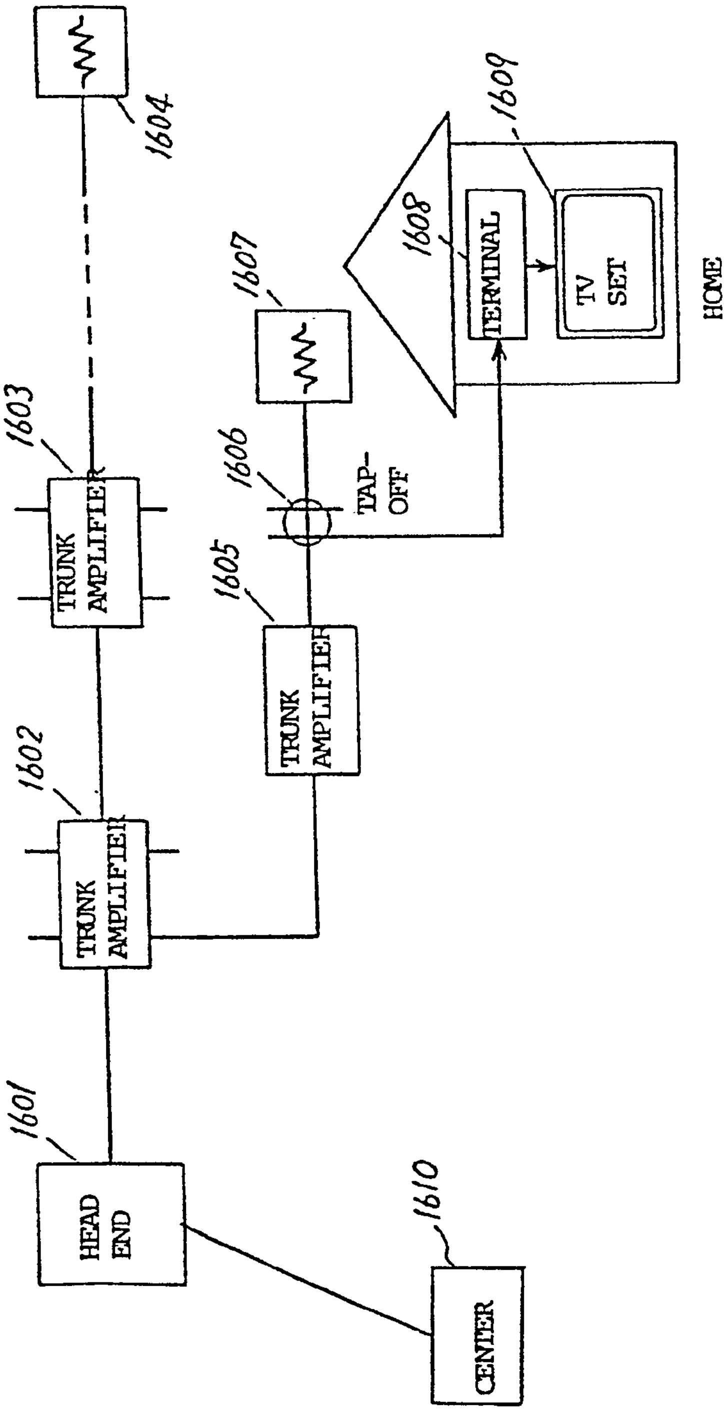
HEAD END
1601
TRUNK AMPLIFIER
1602
TRUNK AMPLIFIER
1603
1604
TRUNK AMPLIFIER
1605
1606
TAP-OFF
1607
1608
TERMINAL
TV SET
1609
HOME
CENTER
1610

FIG.16

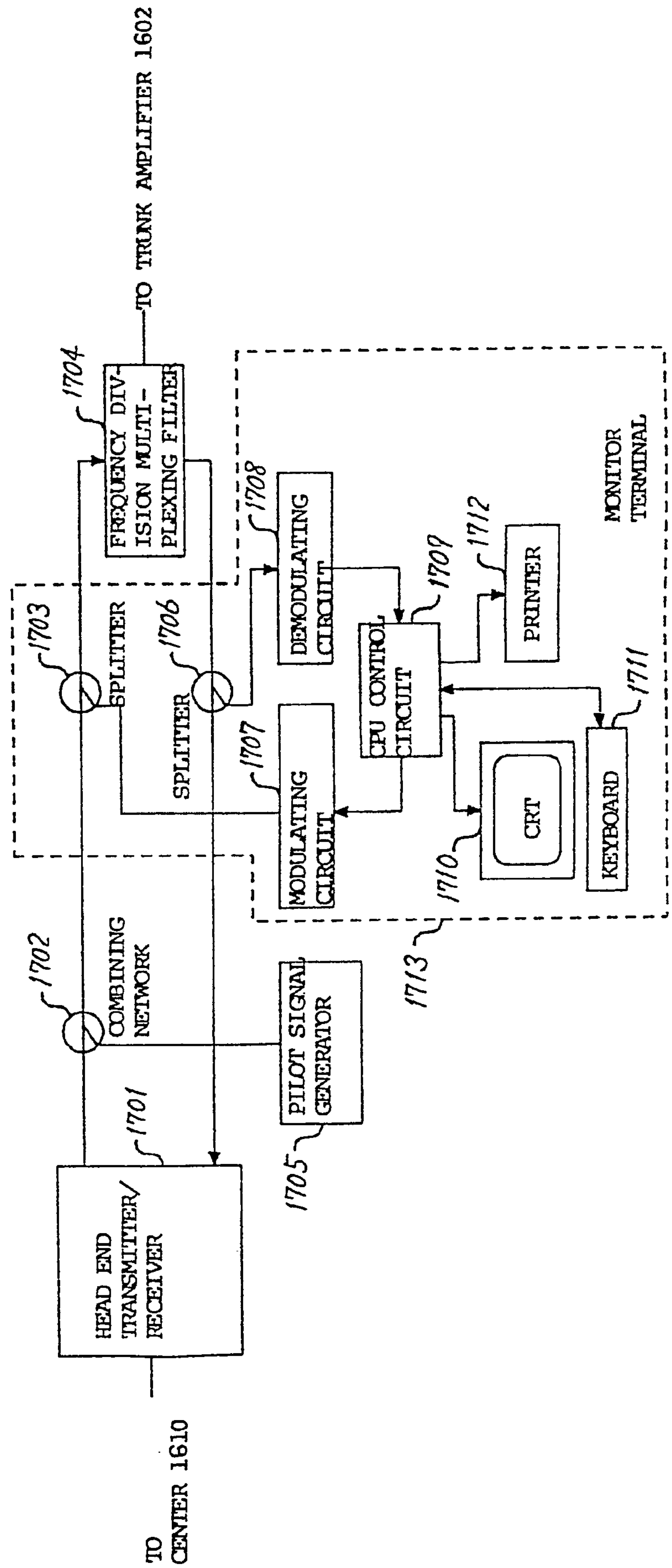
TO TRUNK AMPLIFIER 1602
1704
FREQUENCY DIVISION MULTI-PLEXING FILTER
1703
SPLITTER
1706
SPLITTER
1708
DEMODULATING CIRCUIT
1709
1712
PRINTER
MONITOR TERMINAL
CPU CONTROL CIRCUIT
1711
1707
MODULATING CIRCUIT
CRT
KEYBOARD
1710
1713
1702
COMBINING NETWORK
PILOT SIGNAL GENERATOR
1701
1705
HEAD END TRANSMITTER/RECEIVER
TO CENTER 1610

FIG.17

FIG. 18

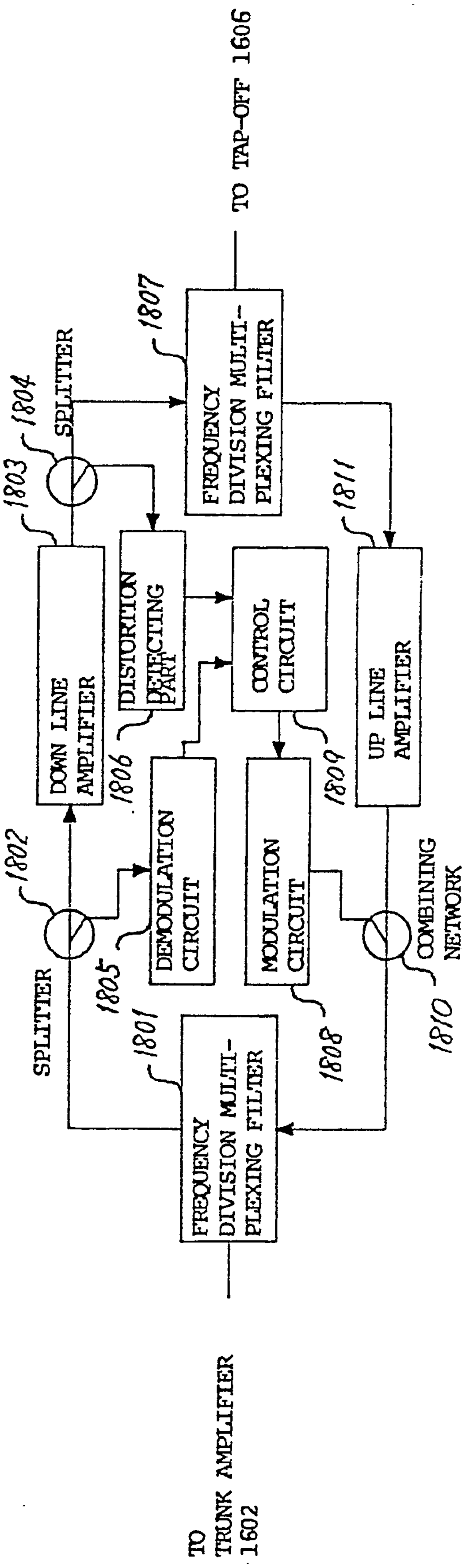
TO TAP-OFF 1606
1807
FREQUENCY DIVISION MULTI-PLEXING FILTER
1804
SPLITTER
1803
1811
DOWN LINE AMPLIFIER
DISTORTION DETECTING PART
CONTROL CIRCUIT
UP LINE AMPLIFIER
1806
1809
1802
DEMODULATION CIRCUIT
MODULATION CIRCUIT
COMBINING NETWORK
1805
SPLITTER
1801
1808
1810
FREQUENCY DIVISION MULTI-PLEXING FILTER
TO TRUNK AMPLIFIER 1602

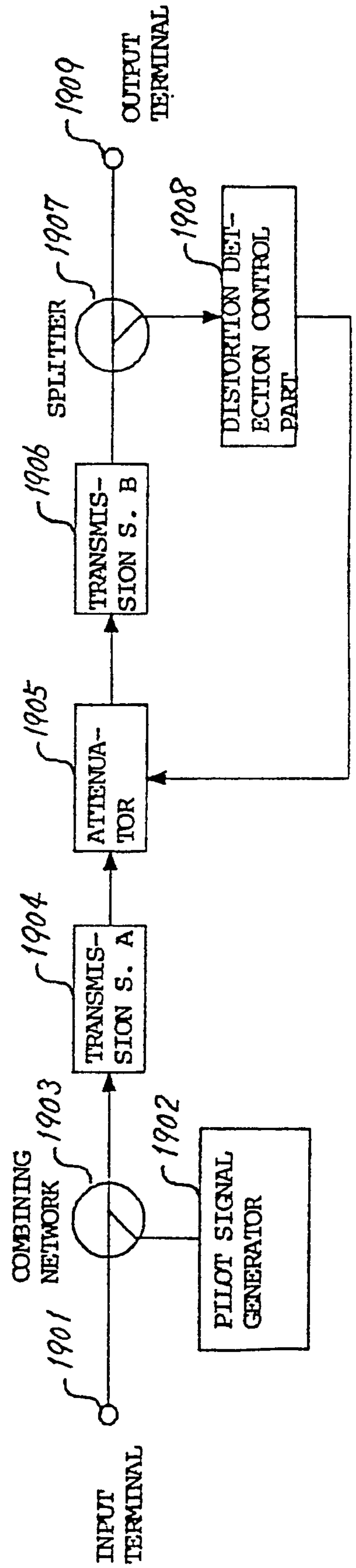
INPUT TERMINAL
1901
COMBINING NETWORK
1903
1902
PILOT SIGNAL GENERATOR
1904
TRANSMIS-SION S. A
1905
ATTENUA-TOR
1906
TRANSMIS-SION S. B
SPLITTER
1907
1908
DISTORTION DET-ECTION CONTROL PART
1909
OUTPUT TERMINAL

FIG. 19

FIG. 20

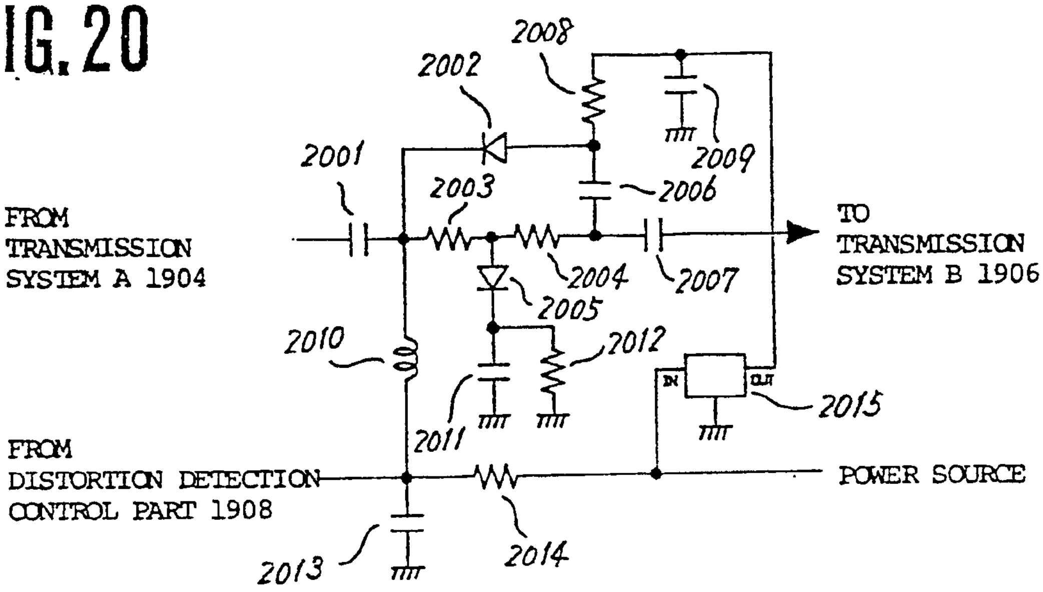
FROM TRANSMISSION SYSTEM A 1904
TO TRANSMISSION SYSTEM B 1906
FROM DISTORTION DETECTION CONTROL PART 1908
POWER SOURCE
2001
2002
2003
2004
2005
2006
2007
2008
2009
2010
2011
2012
2013
2014
2015
IN
OUT

FIG. 21

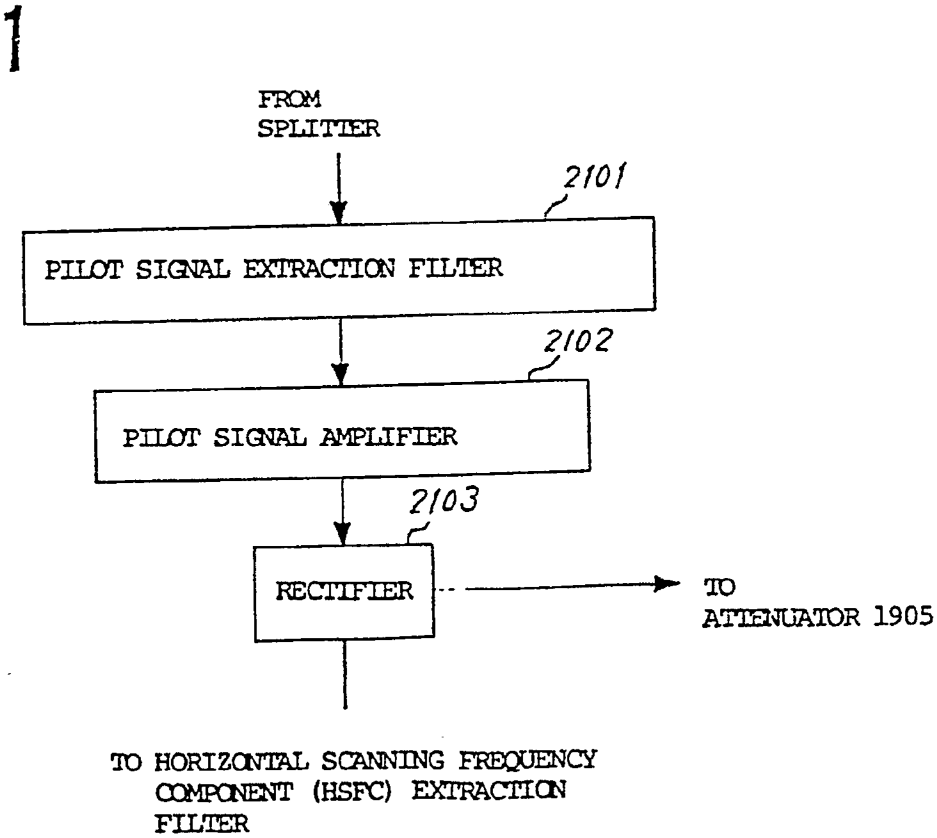
FROM SPLITTER
PILOT SIGNAL EXTRACTION FILTER
2101
PILOT SIGNAL AMPLIFIER
2102
RECTIFIER
2103
TO ATTENUATOR 1905
TO HORIZONTAL SCANNING FREQUENCY COMPONENT (HSFC) EXTRACTION FILTER

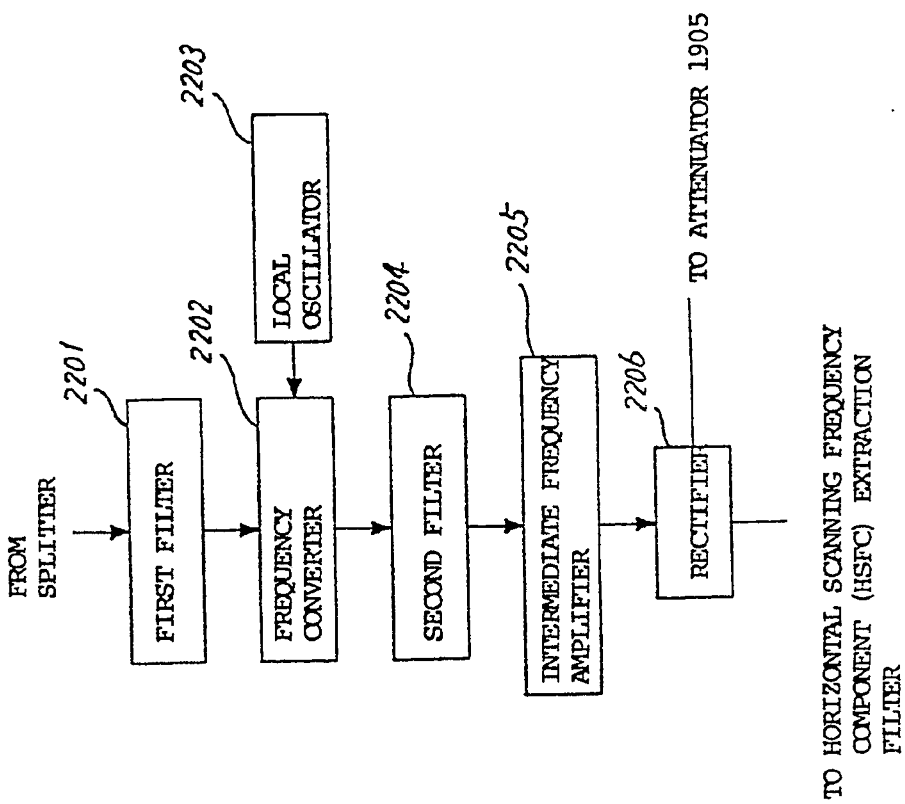
FROM SPLITTER
FIRST FILTER
2201
FREQUENCY CONVERTER
2202
LOCAL OSCILLATOR
2203
SECOND FILTER
2204
INTERMEDIATE FREQUENCY AMPLIFIER
2205
RECTIFIER
2206
TO ATTENUATOR 1905
TO HORIZONTAL SCANNING FREQUENCY COMPONENT (HSFC) EXTRACTION FILTER

FIG. 22

FIG. 24

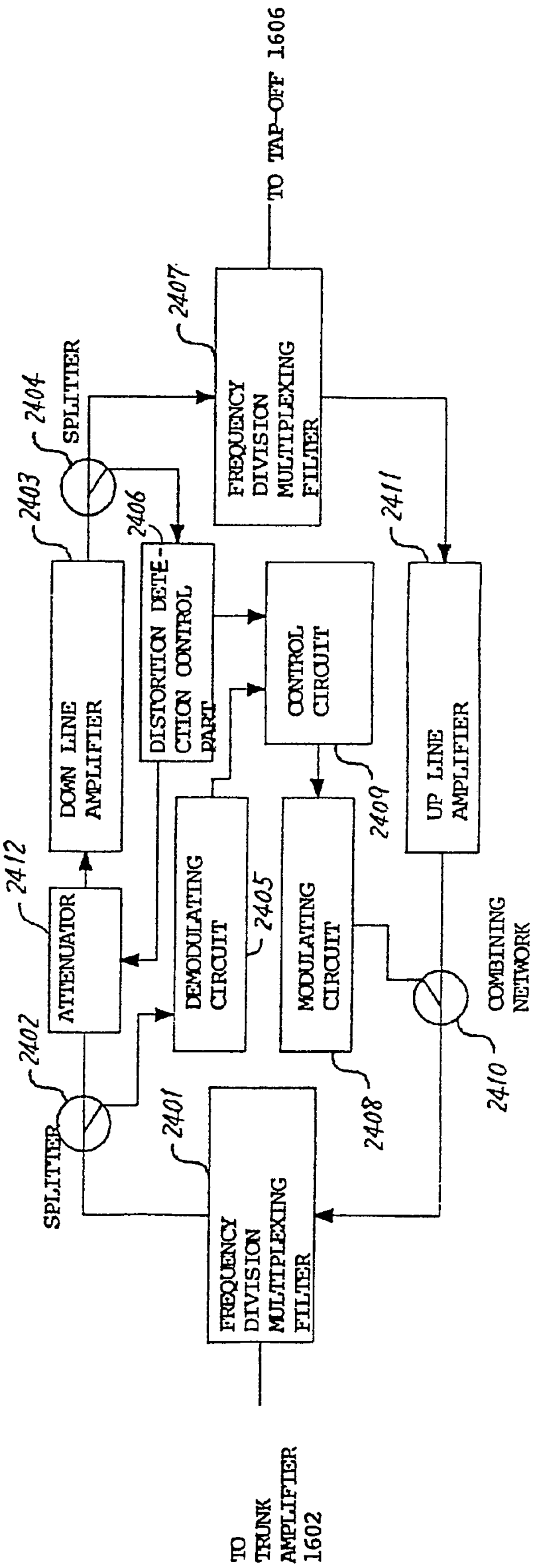
TO TAP-OFF 1606
2407
FREQUENCY DIVISION MULTIPLEXING FILTER
2404
SPLITTER
2403
2406
DISTORTION DETECTION CONTROL PART
DOWN LINE AMPLIFIER
CONTROL CIRCUIT
2409
2411
UP LINE AMPLIFIER
2412
ATTENUATOR
DEMODULATING CIRCUIT
2405
MODULATING CIRCUIT
2408
COMBINING NETWORK
2410
2402
SPLITTER
2401
FREQUENCY DIVISION MULTIPLEXING FILTER
TO TRUNK AMPLIFIER 1602

FIG. 25

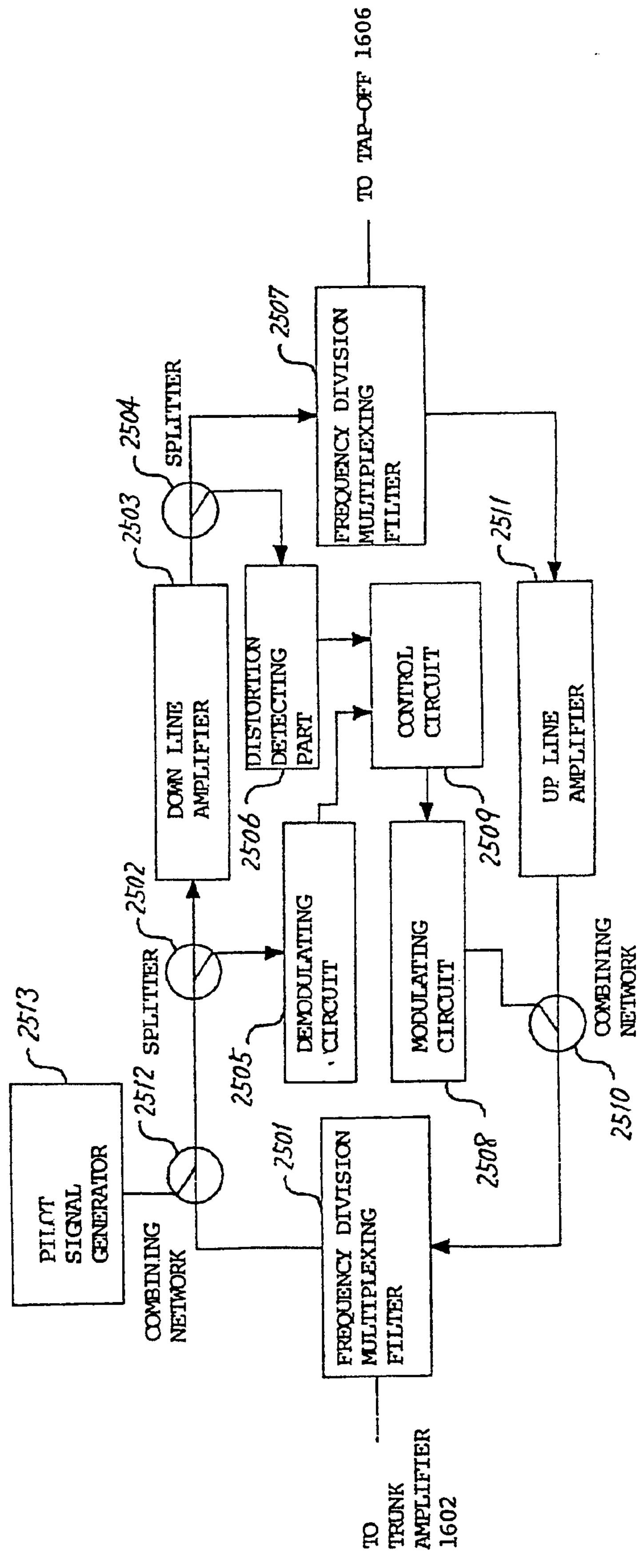
TO TAP-OFF 1606
2507
FREQUENCY DIVISION MULTIPLEXING FILTER
2504
SPLITTER
2503
DISTORTION DETECTING PART
CONTROL CIRCUIT
2511
UP LINE AMPLIFIER
DOWN LINE AMPLIFIER
2506
2509
2502
SPLITTER
DEMODULATING CIRCUIT
MODULATING CIRCUIT
COMBINING NETWORK
2513
2512
2505
2510
PILOT SIGNAL GENERATOR
2501
2508
COMBINING NETWORK
FREQUENCY DIVISION MULTIPLEXING FILTER
TO TRUNK AMPLIFIER 1602